(19) Europäisches Patentamt
European Patent Office
Office européen des brevets

(11) EP 4 727 310 A1

(12) EUROPEAN PATENT APPLICATION
published in accordance with Art. 153(4) EPC

(43) Date of publication:
**15.04.2026 Bulletin 2026/16**

(21) Application number: **24839958.6**

(22) Date of filing: **28.06.2024**

(51) International Patent Classification (IPC):
***H10K 50/15*** (2023.01) ***H10K 50/11*** (2023.01)
***H10K 50/16*** (2023.01) ***H10K 50/81*** (2023.01)
***H10K 50/82*** (2023.01) ***H10K 50/17*** (2023.01)
***H10K 50/19*** (2023.01) ***H10K 50/85*** (2023.01)
***H10K 59/10*** (2023.01) ***H10K 30/50*** (2023.01)

(52) Cooperative Patent Classification (CPC):
**H10K 30/50; H10K 50/11; H10K 50/15; H10K 50/16; H10K 50/17; H10K 50/19; H10K 50/81; H10K 50/82; H10K 50/85; H10K 59/10**

(86) International application number:
**PCT/KR2024/009135**

(87) International publication number:
**WO 2025/014144 (16.01.2025 Gazette 2025/03)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **12.07.2023 KR 20230090539**

(71) Applicant: **Duk San Neolux Co., Ltd.**
**Chungcheongnam-do 31027 (KR)**

(72) Inventors:
- **SONG, Wook**
  **Cheonan-si, Chungcheongnam-do 31027 (KR)**
- **OH, Hyun Ji**
  **Cheonan-si, Chungcheongnam-do 31027 (KR)**
- **HAN, Sung Yong**
  **Cheonan-si, Chungcheongnam-do 31027 (KR)**

(74) Representative: **Isarpatent**
**Patent- und Rechtsanwälte PartG mbB**
**Friedrichstraße 31**
**80801 München (DE)**

# (54) ORGANIC ELECTRIC ELEMENT COMPRISING COMPOUND FOR ORGANIC ELECTRIC ELEMENT, AND ELECTRONIC DEVICE THEREFOR

(57) The present invention provides an organic electric element including a first electrode, a second electrode, and at least one organic material layer between the first electrode and the second electrode, and an electronic element including same. The organic material layer includes a hole transport region, an emitting layer, and an electron transport region, wherein the hole transport layer comprises a compound having a capacitance of less than 1 nF in a range of 0 V to 1 V as measured for capacitance-voltage at 120 Hz and ±0.1 V, thereby lowering a driving voltage of the organic electronic element and improving luminous efficiency and lifespan.

FIG. 1

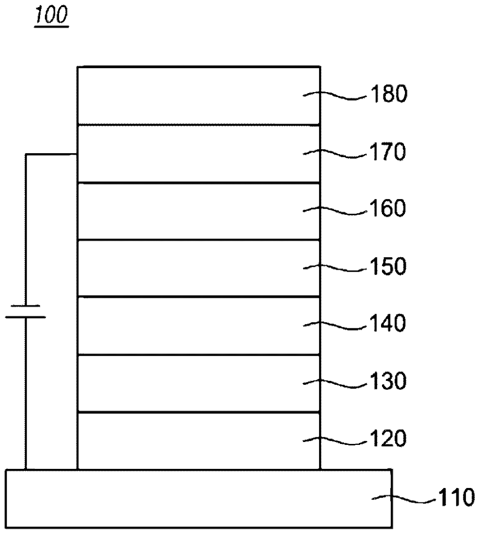

## Description

## BACKGROUND

### [Technical Field]

The present invention relates to an organic electronic element using a compound for organic electronic element, and electronic device thereof.

### [Background Art]

In general, organic light emitting phenomenon refers to a phenomenon that converts electric energy into light energy by using an organic material. An organic electronic element using an organic light emitting phenomenon usually has a structure including an anode, a cathode, and an organic material layer interposed therebetween. Here, in order to increase the efficiency and stability of the organic electronic element, the organic material layer is often composed of a multi-layered structure composed of different materials, and for example, may include a hole injection layer, a hole transport layer, an emitting layer, an electron transport layer, an electron injection layer etc.

A material used as an organic material layer in an organic electronic element may be classified into a light emitting material and a charge transport material, such as a hole injection material, a hole transport material, an electron transport material, an electron injection material etc. depending on its function.

The biggest issues with organic light emitting devices are their lifespan and efficiency, and as displays become larger in size, these efficiency and lifespan issues must be resolved. Efficiency, lifespan, and driving voltage are interrelated. As efficiency increases, the driving voltage decreases relatively. As the driving voltage decreases, the crystallization of organic materials due to Joule heating generated during operation decreases, which results in a tendency for the lifespan to increase.

However, the efficiency cannot be maximized simply by improving the organic material layer. This is because, when the energy level and T1 value between each organic material layer, and the intrinsic properties (mobility, interfacial properties, etc.) of materials are optimally combined, long lifetime and high efficiency can be achieved at the same time.

In general, when a voltage above a certain level is applied to the two electrodes of an OLED device, at the anode, holes move to the internal organic material layer, and at the cathode, electrons move to the internal organic material layer. The capacitance of the OLED device changes according to this internal charge movement.

At this time, if a hole accumulation phenomenon occurs in which holes do not move smoothly and holes continue to accumulate in the hole transport layer, the capacitance in the hole transport layer increases. When this hole accumulation phenomenon occurs, charge transfer is not smooth, so charge injection into the emitting layer becomes relatively slow, which causes charges and electrons to meet late in the emitting layer, resulting in light emission at an undesirable time or a low-gray phenomenon in which current flows even when power supply is stopped due to charges remaining at the interface. The phenomenon ultimately leads to a deterioration in the image quality of OLED device panels.

Therefore, it is important to minimize capacitance changes in the hole transport layer of OLED devices to prevent capacitance increases.

That is, in order to fully demonstrate the excellent characteristics of organic electronic elements, the materials forming the organic material layers within the devices, such as hole injection materials, hole transport materials, emitting materials, electron transport materials, electron injection materials, and emitting-auxiliary layer materials, must first be supported by stable and efficient materials. However, the development of stable and efficient organic material layer materials for organic electronic elements has not yet been sufficiently accomplished. Therefore, the development of new materials continues to be required.

## DETAILED DESCRIPTION OF THE INVENTION

### [Summary]

The present invention aims to provide an organic electronic element and an electronic device thereof comprising a compound capable of lowering the driving voltage of the element and improving the luminous efficiency, color purity, stability and lifespan of the element.

### [Technical Solution]

The present invention provides an organic electronic element comprising: a first electrode; a second electrode; and at least one organic material layer between the first electrode and the second electrode; wherein the organic material

layer comprises a hole transport region, an emitting layer, and an electron transport region, and wherein the hole transport region has a capacitance of less than 1 nF within a range of 0 V to 1 V when capacitance-voltage is measured under conditions of 120 Hz and ±0.1 V.

In another aspect, the present invention provides an electronic device comprising the organic electronic element.

**[Effects of the Invention]**

By using the compound according to the present invention, it is possible to achieve a high luminous efficiency, a low driving voltage, and a high heat resistance of the element, and can greatly improve the color purity and lifespan of the element.

**[BRIEF DESCRIPTION OF THE DRAWINGS]**

FIG. 1 to FIG. 3 illustrate an example of an organic electronic element according to the present invention.

FIG. 4 is a graph of capacitance-voltage data measurements according to hole transport layer materials with a measurement standard of 120 Hz and ±0.1 V according to one embodiment.

FIG. 5 is a graph showing the driving voltage measurement of an organic light-emitting device according to one embodiment.

**[DETAILED DESCRIPTION]**

Hereinafter, some embodiments of the present invention will be described in detail. Further, in the following description of the present invention, a detailed description of known functions and configurations incorporated herein will be omitted when it may make the subject matter of the present invention rather unclear.

Additionally, terms, such as first, second, A, B, (a), (b) or the like may be used herein when describing components of the present invention. Each of these terminologies is not used to define an essence, order or sequence of a corresponding component but used merely to distinguish the corresponding component from other component(s). It should be noted that if a component is described as being "connected", "coupled", or "connected" to another component, the component may be directly connected or connected to the other component, but another component may be "connected ", " coupled" or "connected" between each component.

As used in the specification and the accompanying claims, unless otherwise stated, the following is the meaning of the term as follows.

Unless otherwise stated, the term "halo" or "halogen" , as used herein, includes fluorine(F), bromine(Br), chlorine(Cl), or iodine(I).

Unless otherwise stated, the term "alkyl" or "alkyl group" , as used herein, has a single bond of 1 to 60 carbon atoms, 1 to 30 carbon atoms, 1 to 25 carbon atoms, 1 to 18 carbon atoms, or 1 to 12 carbon atoms, and means saturated aliphatic functional radicals including a linear alkyl group, a branched chain alkyl group, a cycloalkyl group (alicyclic), an cycloalkyl group substituted with a alkyl or an alkyl group substituted with a cycloalkyl.

Unless otherwise stated, the term "alkenyl" or "alkynyl" , as used herein, has double or triple bonds of 2 to 60 carbon atoms, 2 to 30 carbon atoms, 2 to 25 carbon atoms, 2 to 18 carbon atoms, 2 to 12 carbon atoms, but is not limited thereto, and includes a linear or a branched chain group.

Unless otherwise stated, the term "cycloalkyl" , as used herein, means alkyl forming a ring having 3 to 60 carbon atoms, 3 to 30 carbon atoms, 3 to 25 carbon atoms, 3 to 18 carbon atoms, 3 to 12 carbon atoms, but is not limited thereto.

Unless otherwise stated, the term "alkoxyl group" , "alkoxy group" or "alkyloxy group" , as used herein, means an alkyl group bonded to oxygen radical, but is not limited thereto, and has 1 to 60 carbon atoms, 1 to 30 carbon atoms, 1 to 25 carbon atoms, 1 to 18 carbon atoms, or 1 to 12 carbon atoms.

Unless otherwise stated, the term "aryloxyl group" or "aryloxy group" , as used herein, means an aryl group bonded to oxygen radical, but is not limited thereto, and has 6 to 60 carbon atoms, 6 to 30 carbon atoms, 6 to 25 carbon atoms, 6 to 18 carbon atoms, or 6 to 12 carbon atoms.

Unless otherwise specified, the terms "aryl group" and "arylene group" used in the present invention have 6 to 60 carbon atoms, 6 to 30 carbon atoms, 6 to 25 carbon atoms, 6 to 18 carbon atoms, or 6 to 12 carbon atoms, respectively, but are not limited thereto. In the present invention, an aryl group or arylene group refers to an aromatic group of a single ring or multiple rings, and comprises an aromatic ring formed by the bonding or reaction of adjacent substituents. For example, the aryl group may be phenyl, biphenyl, a fluorene group, a spirofluorene group.

The prefix "aryl" or "ar" means a radical substituted with an aryl group. For example, an arylalkyl may be an alkyl substituted with an aryl, and an arylalkenyl may be an alkenyl substituted with aryl, and a radical substituted with an aryl has a number of carbon atoms as defined herein. Also, when prefixes are named subsequently, it means that substituents are listed in the order described first. For example, an arylalkoxy means an alkoxy substituted with an aryl, an alkoxylcarbonyl means a carbonyl substituted with an alkoxyl, and an arylcarbonylalkenyl also means an alkenyl substituted with an arylcarbonyl, wherein the arylcarbonyl may be a carbonyl substituted with an aryl.

Unless otherwise stated, the term "heterocyclic group" , as used herein, contains one or more heteroatoms, and has 2 to 60 carbon atoms, 2 to 30 carbon atoms, 2 to 25 carbon atoms, 2 to 18 carbon atoms, 2 to 12 carbon atoms, and comprises any one of a single ring or multiple ring, and may include heteroaliphatic ring and heteroaromatic ring. Also, the heterocyclic group can also be formed in conjunction with adjacent functional groups.

Unless otherwise stated, the term "heteroatom" , as used herein, represents at least one of N, O, S, P, or Si.

Additionally, "heterocyclic group" means a single ring, ring aggregate, fused multiple ring system, spiro compound, etc. containing a heteroatom. Also, compounds containing heteroatom groups such as $SO_2$, P=O, etc. instead of carbon forming a ring, such as the compounds below, can also be included in the heterocyclic group. For example, a "heterocyclic group" includes the following compound.

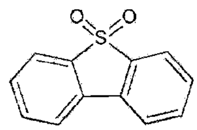

The term "aliphatic ring group" used in the present invention refers to cyclic hydrocarbons excluding aromatic hydrocarbons, and includes single rings, ring aggregates, fused multiple ring systems, spiro compounds, etc., and means a ring having 3 to 60 carbon atoms, 3 to 30 carbon atoms, 3 to 25 carbon atoms, 3 to 18 carbon atoms, 3 to 12 carbon atoms, but is not limited thereto. For example, even when benzene, an aromatic ring, and cyclohexane, a non-aromatic ring, are fused, it is an aliphatic ring.

Unless otherwise stated, the term "fluorenyl group" , "fluorenylene group" or "fluorentriyl group" as used herein, means a monovalent, divalent or trivalent functional group, in which R, R' and R" are all hydrogen in the following structures, and the term "substituted fluorenyl group" , "substituted fluorenylene group" or "substituted fluorentriyl group" means that at least one of the substituents R, R' and R" is a substituent other than hydrogen, and include those in which R and R' are bonded to each other to form a spiro compound together with the carbon to which they are bonded. In this specification, fluorenyl group, fluorenylene group, and fluorenetriyl group may all be referred to as fluorene groups, regardless of valence.

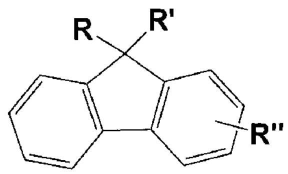

The term "spiro compound" used in the present invention has a 'spiro union', and a spiro union means a connection formed by 2 rings sharing only one atom. At this time, the atom shared between the 2 rings is called a 'spiro atom', and depending on the number of spiro atoms contained in a compound, they are called 'monospiro-', 'dispiro-', and 'trispiro-' compounds, respectively.

Unless otherwise stated, the term "aliphatic" as used herein means an aliphatic hydrocarbon having 1 to 60 carbon atoms, 1 to 30 carbon atoms, 1 to 25 carbon atoms, 1 to 18 carbon atoms or 1 to 12 carbon atoms, and "aliphatic ring" means an aliphatic hydrocarbon ring having 3 to 60 carbon atoms, 3 to 30 carbon atoms, 3 to 25 carbon atoms, 3 to 18 carbon atoms or 3 to 12 carbon atoms.

Unless otherwise stated, the term "ring" , as used herein, means an aliphatic ring having 3 to 60 carbon atoms, 3 to 30 carbon atoms, 3 to 25 carbon atoms, 3 to 18 carbon atoms or 3 to 12 carbon atoms; or an aromatic ring having 6 to 60 carbon atoms, 6 to 30 carbon atoms, 6 to 25 carbon atoms, 6 to 18 carbon atoms, or 6 to 12 carbon atoms; or a heterocyclic having 2 to 60 carbon atoms, 2 to 30 carbon atoms, 2 to 25 carbon atoms, 2 to 18 carbon atoms, 2 to 12 carbon atoms, or a fused ring formed by the combination thereof, and includes a saturated or unsaturated ring.

Other hetero compounds or hetero radicals other than the above-mentioned hetero compounds include, but are not limited thereto, one or more heteroatoms.

Also, unless expressly stated, as used herein, "substituted" in the term "substituted or unsubstituted" means substituted with one or more substituents selected from the group consisting of deuterium, halogen, an amino group, a

nitrile group, a nitro group, a $C_1$-$C_{20}$ alkyl group, a $C_1$-$C_{20}$ alkoxyl group, a $C_1$-$C_{20}$ alkylamine group, a $C_1$-$C_{20}$ alkylthiopen group, a $C_6$-$C_{20}$ arylthiopen group, a $C_2$-$C_{20}$ alkenyl group, a $C_2$-$C_{20}$ alkynyl group, a $C_3$-$C_{20}$ cycloalkyl group, a $C_6$-$C_{20}$ aryl group, a $C_6$-$C_{20}$ aryl group substituted by deuterium, a $C_8$-$C_{20}$ arylalkenyl group, a silane group, a boron group, a germanium group, and a $C_2$-$C_{20}$ heterocyclic group, but is not limited to these substituents.

In this specification, the 'group name' corresponding to the aryl group, arylene group, heterocyclic group, etc., as examples of each symbol and its substituent, may be written as the 'name of the group reflecting the valence', but is written as the 'parent compound name'. For example, in the case of 'phenanthrene', a type of aryl group, the name of the group may be written by distinguishing the valence, such as the monovalent 'group' is 'phenanthryl' and the divalent group is 'phenanthrylene', but may be written as 'phenanthrene', which is the name of the parent compound, regardless of the valence. Similarly, in the case of pyrimidine, it can be written as 'pyrimidine' regardless of the valence, or it can be written as the 'name of the group' of the valence, such as pyrimidineyl group in the case of monovalent group, pyrimidineylene in the case of divalent group, etc. Additionally, in this specification, when describing compound names or substituent names, numbers or alphabets indicating positions may be omitted. For example, pyrido[4,3-d]pyrimidine to pyridopyrimidine, benzofuro[2,3-d]pyrimidine to benzofuropyrimidine, 9,9-dimethyl-9H-fluorene can be described as dimethylfluorene, etc. Therefore, both benzo[g]quinoxaline and benzo[f]quinoxaline can be described as benzoquinoxaline.

Also, unless there is an explicit explanation, the formula used in the present invention is the same as the definition of the substituent by the exponent definition of the following formula.

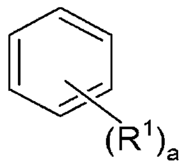

Here, when a is an integer of O, the substituent $R^1$ is absent, when a is an integer of 1, the sole substituent $R^1$ is linked to any one of the carbon constituting the benzene ring, when a is an integer of 2 or 3, each is combined as follows, where $R^1$ may be the same or different from each other, when a is an integer of 4 to 6, it is bonded to the carbon of the benzene ring in a similar manner, while the indication of the hydrogen bonded to the carbon forming the benzene ring is omitted.

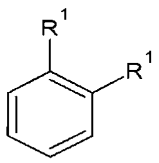

(a=2)

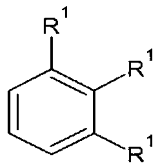

(a=3)

Unless otherwise expressly stated, the terms "ortho", "meta", and "para" used in the present invention refer to the substitution positions of all substituents, and the ortho position refers to a compound in which the position of the substituent is immediately adjacent, for example, when benzene is used, it means 1 or 2 position, and the meta position is the next substitution position of the neighbor substitution position, when benzene as an example stands for 1 or 3 position, and the para position is the next substitution position of the meta position, which means 1 and 4 position when benzene is taken as an example. A more detailed example of the substitution position is as follows, and it can be confirmed that the ortho-, and meta- position are substituted by non-linear type and para- positions are substituted by linear type.

[Example of ortho-position]

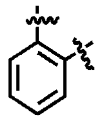 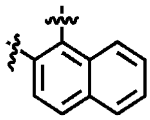 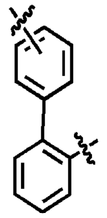 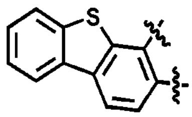 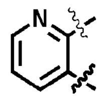 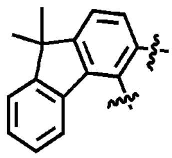

[Example of meta-position]

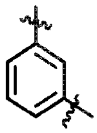 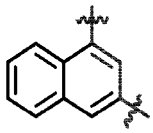 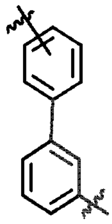 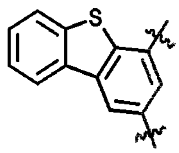 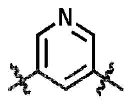 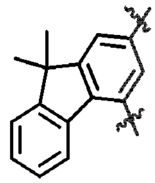

[Example of para-position]

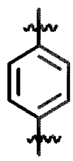 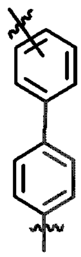 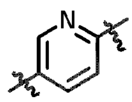

In general, capacitance refers to how much charge can be stored, when a dielectric is placed between two electrode plates and voltage is applied and the symbol for capacitance is C, and the unit is farad [F].

If the charge accumulated in a capacitor is Q and the applied voltage is V, a capacitance of 1F means that when a voltage of 1V is applied to the capacitor, a charge of 1C (coulomb) can be accumulated between two parallel plates. Here, voltage (V) and charge (Q) are proportional, so the higher the voltage (V), the more charge (Q) is charged. The relationship between voltage, charge, and capacitance is expressed in an equation as follows.

$$Q = C \times V$$

The three physical factors of capacitance are 1) the active area of the capacitor conductors (plates), 2) the distance between the conductors, and 3) the permittivity of the dielectric medium used between the conductors. By applying these, the capacitance can be expressed by the following equation. Here, the closer the distance (d) between the two electrodes, the larger the area (A) of the electrode plates, and the larger the relative permittivity ( $\varepsilon r$), the more charge (C) is charged.

$$C = \frac{\varepsilon_r \, \varepsilon_0 \times A}{d}$$

εr: relative permittivity (dielectric constant), ε0: permittivity in vacuum, A: area of electrode plates, d: distance between two electrodes

An OLED device can be viewed as a single capacitor composed of multiple layers of organic material (dielectric) sandwiched between two electrodes. However, OLED devices differ in that these multiple layers of organic material structure energy levels in a stepped fashion, allowing charge to flow above a certain voltage. Therefore, unlike a typical capacitor, when a voltage above a certain level is applied to the two electrodes of an OLED device, holes move from the anode to the internal organic material layer, and electrons move from the cathode to the internal organic material layer. The capacitance of the OLED device changes according to this internal charge movement. That is, charges move between multiple layers of organic materials in an OLED device, and capacitance refers to a quantity that represents the ratio of the amount of charge accumulated in each layer according to this charge mobility.

In particular, an increase in capacitance in the hole transport layer indicates the occurrence of a hole accumulation phenomenon, in which holes are unable to move smoothly and are accumulated. In other words, this refers to the continuous accumulation of charges (holes) in the hole transport layer, resulting in an increase in residual holes within the hole transport layer or at its interface. When this hole accumulation phenomenon occurs, charge transfer is not smooth, so charge injection into the emitting layer is relatively slow. This causes the charges and electrons in the emitting layer to meet late, resulting in undesirable light emission or a low-gray phenomenon in which current flows even when the power supply is cut off due to the charges remaining at the interface. This phenomenon ultimately causes a problem of deterioration in the image quality of the OLED element panel.

Therefore, it is important to minimize the capacitance change in the hole transport layer in the OLED device so that the capacitance does not increase, and in the present invention, the hole accumulation phenomenon can be resolved by using an organic material having a capacitance of less than 1 nF within the range of 0 V to 1 V when measuring capacitance-voltage as the hole transport layer material. As a result, the time for charges to accumulate at the interface in the hole transport layer is shortened, allowing for smooth charge supply to the emitting layer, thereby resolving the low-gray phenomenon and improving the stability of the OLED device.

Hereinafter, the laminated structure of an organic electronic element comprising the compound of the present invention will be described with reference to FIGS. 1 to 3.

When assigning reference numerals to components in each drawing, it should be noted that identical components are assigned the same numerals whenever possible, even if they appear on different drawings. Furthermore, when describing the present invention, if a detailed description of a related known configuration or function is deemed likely to obscure the gist of the present invention, such detailed description will be omitted.

Figs 1 to 3 are exemplary diagrams of organic electronic elements according to embodiments of the present invention.

Referring to FIG. 1, an organic electronic element (100) according to embodiments of the present invention comprises a first electrode (110) formed on a substrate (not shown), a second electrode (170), and an organic material layer between the first electrode (110) and the second electrode (170).

Wherein, the first electrode (110) may be an anode (positive electrode), and the second electrode (170) may be a cathode (negative electrode). In the case of an inverted organic electronic element, the first electrode may be a cathode, and the second electrode may be an anode.

The organic material layer may sequentially comprise a hole injection layer (120), a hole transport layer (130), an emitting layer (140), an electron transport layer (150), and an electron injection layer (160). Specifically, a hole injection layer (120), a hole transport layer (130), an emitting layer (140), an electron transport layer (150), and an electron injection layer (160) can be sequentially formed on the first electrode (110).

Preferably, a light efficiency enhancing layer (180) may be formed on one side of the first electrode (110) or the second electrode (170) that is not in contact with the organic material layer, and when the light efficiency enhancing layer (180) is formed, the light efficiency of the organic electronic element may be improved.

For example, a light efficiency enhancing layer (180) can be formed on the second electrode (170). In the case of a top emission organic light emitting device, the formation of the light efficiency enhancing layer (180) can reduce optical energy loss due to SPPs (surface plasmon polaritons) in the second electrode (170), and in the case of a bottom emission organic light emitting device, the light efficiency improvement layer (180) can serve as a buffer for the second electrode (170).

A buffer layer (210) or an emitting auxiliary layer (220) may be further formed between the hole transport layer (130) and the emitting layer (140), which will be described with reference to FIG. 2.

Referring to FIG. 2, an organic electronic element (200) according to another embodiment of the present invention may comprise a hole injection layer (120), a hole transport layer (130), a buffer layer (210), an emitting auxiliary layer (220), an emitting layer (140), an electron transport layer (150), an electron injection layer (160), and a second electrode (170) sequentially formed on a first electrode (110), and a light efficiency enhancing layer (180) may be formed on the second electrode.

Although not illustrated in FIG. 2, an electron transport auxiliary layer may be further formed between the emitting

layer (140) and the electron transport layer (150).

Furthermore, according to another embodiment of the present invention, the organic material layer may be formed in a form in which multiple stacks comprising a hole transport layer, an emitting layer, and an electron transport layer are formed. This will be described with reference to FIG. 3.

Referring to FIG. 3, an organic electric element (300) according to another embodiment of the present invention may have 2 or more sets of stacks (ST1, ST2) of organic material layers formed in multiple layers formed between a first electrode (110) and a second electrode (170), and a charge generation layer (CGL) may be formed between the stacks of organic material layers.

Specifically, an organic electronic element according to one embodiment of the present invention may comprise a first electrode (110), a first stack (ST1), a charge generation layer (CGL), a second stack (ST2), a second electrode (170), and a light efficiency enhancing layer (180).

The first stack (ST1) is an organic material layer formed on the first electrode (110), which may include a first hole injection layer (320), a first hole transport layer (330), a first emitting layer (340), and a first electron transport layer (350), and the second stack (ST2) may include a second hole injection layer (420), a second hole transport layer (430), a second emitting layer (440), and a second electron transport layer (450). In this way, the first stack and the second stack may be organic material layers having the same laminated structure, but may also be organic material layers having different laminated structures.

A charge generation layer (CGL) may be formed between the first stack (ST1) and the second stack (ST2). The charge generation layer (CGL) may comprise a first charge generation layer (360) and a second charge generation layer (361). The charge generation layer (CGL) is formed between the first emitting layer (340) and the second emitting layer (440) to increase the current efficiency generated in each emitting layer and to smoothly distribute charges.

When a plurality of emitting layers are formed by a multi-layer stack structure as shown in Fig. 3, not only can an organic light-emitting device that emits white light be manufactured by the mixing effect of the light emitted from each emitting layer, but an organic light-emitting device that emits light of various colors can also be manufactured.

The compound represented by Formula 1 of the present invention can be used as a material for a hole injection layer (120, 320, 420), a hole transport layer (130, 330, 430), a buffer layer (210), an emitting auxiliary layer (220), an electron transport layer (150, 350, 450), an electron injection layer (160), an emitting layer (140, 340, 440), or a light efficiency enhancing layer (180), but preferably, the compound represented by Formula 1 of the present invention can be used as a hole transport layer (130, 330, 430).

Even if the core is identical or similar, the band gap, electrical properties, and interface properties can vary depending on which substituent is bonded at which position. Therefore, research on the selection of the core and the combination of sub-substituents bonded to it is necessary. In particular, when the energy level and T1 value between each organic material layer and the intrinsic properties of the material (mobility, interface properties, etc.) are optimally combined, long life and high efficiency can be achieved simultaneously.

An organic light emitting device according to an embodiment of the present invention may be manufactured using various deposition methods. It may be manufactured using a deposition method such as PVD or CVD. For example, it may be manufactured by forming an anode (110) by depositing a metal or a conductive metal oxide or an alloy thereof on a substrate, forming an organic material layer comprising a hole injection layer (120), a hole transport layer (130), an emitting layer (140), an electron transport layer (150), and an electron injection layer (160) thereon, and then depositing a material that can be used as a cathode (170) thereon. Additionally, an emitting auxiliary layer (220) may be further formed between the hole transport layer (130) and the emitting layer (140), and an electron transport auxiliary layer (not shown) may be further formed between the emitting layer (140) and the electron transport layer (150), or may be formed in a stack structure as described above.

Additionally, the organic material layer can be manufactured with a smaller number of layers by using various polymer materials and a solution process or solvent process other than a deposition method, such as a spin coating process, a nozzle printing process, an inkjet printing process, a slot coating process, a dip coating process, a roll-to-roll process, a doctor blading process, a screen printing process, or a thermal transfer method. Since the organic material layer according to the present invention can be formed by various methods, the scope of the present invention is not limited by the formation method.

Additionally, the organic electronic element according to one embodiment of the present invention may be selected from the group consisting of an organic light-emitting device, an organic solar cell, an organic photoconductor, an organic transistor, a device for monochrome lighting, and a device for quantum dot display.

Another embodiment of the present invention may include a display device comprising the organic electronic element of the present invention described above, and an electronic device comprising a control unit for controlling the display device. In this case, the electronic device may be a current or future wired or wireless communication terminal, and includes all electronic devices such as mobile communication terminals such as cell phones, PDAs, electronic dictionaries, PMPs, remote controls, navigation systems, game consoles, various TVs, and various computers.

Hereinafter, an organic electronic element according to one aspect of the present invention will be described.

An organic electronic element according to one embodiment of the present invention comprises: a first electrode; a second electrode; and at least one organic material layer between the first electrode and the second electrode; wherein the organic material layer comprises a hole transport region, a emitting layer, and an electron transport region, wherein the hole transport region has a capacitance of less than 1 nF within the range of 0 V to 1 V when measuring capacitance-voltage under conditions of 120 Hz and ±0.1 V.

Additionally, the hole transport region has a difference between the capacitance at 0 V and the capacitance at 1 V of 0.01 nF to 0.3 nF when measuring capacitance-voltage under the conditions of 120 Hz and ± 0.1 V.

Additionally, the hole transport region has a difference between the capacitance at 0 V and the capacitance at 1 V of less than 0.1 nF when measuring capacitance-voltage under the conditions of 120 Hz and ±0.1 V.

It is preferable that the hole transport region comprises at least one hole injection layer and at least one hole transport layer.

The organic electronic element may comprise at least one emitting auxiliary layer between the hole transport region and the emitting layer.

Additionally, when measuring capacitance-voltage under conditions of 120 Hz and ±0.1 V, the hole transport region with a capacitance of less than 1 nF within the range of 0 V to 1 V is the hole transport layer.

Additionally, the hole transport layer comprises a compound represented by Formula 1.

<Formula 1>

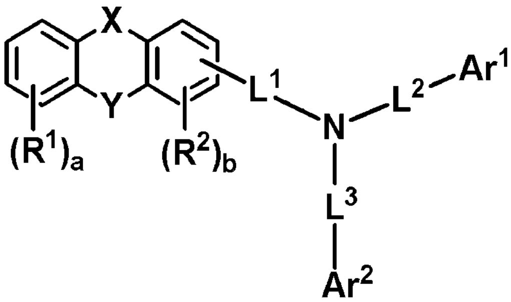

wherein:

X is O, S, $CR^{11}R^{12}$ or $NR^{13}$,

Y is single bond; or $CR^{14}R^{15}$; or non-existent,

$R^{11}$, $R^{12}$, $R^{13}$, $R^{14}$ and $R^{15}$ are independently selected from the group consisting of a $C_6$-$C_{60}$ aryl group; a $C_2$-$C_{60}$ heterocyclic group including at least one heteroatom of O, N, S, Si and P; a fluorenyl group; a fused ring group of a $C_3$-$C_{60}$ aliphatic ring and a $C_6$-$C_{60}$ aromatic ring; a $C_1$-$C_{50}$ alkyl group; a $C_2$-$C_{20}$ alkenyl group; a $C_2$-$C_{20}$ alkynyl group; a $C_1$-$C_{30}$ alkoxyl group; and a $C_6$-$C_{30}$ a aryloxy group; and $R^{11}$ and $R^{12}$ or $R^{14}$ and $R^{15}$ may be bonded to each other to form a ring,

Wherein when $R^{11}$, $R^{12}$, $R^{13}$, $R^{14}$ and $R^{15}$ are an aryl group, preferably an $C_6$-$C_{30}$ aryl group, more preferably an $C_6$-$C_{25}$ aryl group, an $C_6$-$C_{18}$ aryl group or an $C_6$-$C_{12}$ aryl group, such as phenyl, biphenyl, terphenyl, naphthalene, phenanthrene, chrysene, etc.

Wherein when $R^{11}$, $R^{12}$, $R^{13}$, $R^{14}$ and $R^{15}$ are a heterocyclic group, preferably a $C_2$-$C_{30}$ heterocyclic group, more preferably a $C_2$-$C_{25}$ heterocyclic group, a $C_2$-$C_{18}$ heterocyclic group, or a $C_2$-$C_{12}$ heterocyclic group, such as pyrazine, thiophene, pyridine, pyrimidine, quinoline, pyrimidoindole, 5-phenyl-5H-pyrimido[5,4-b]indole, quinazoline, quinoxaline, benzoquinazoline, carbazole, dibenzoquinazoline, benzofuran, benzothiophene, dibenzofuran, dibenzothiophene, benzothienopyrimidine, benzofuropyrimidine, phenothiazine, phenylphenothiazine, benzocarbazole, naphthobenzofuran, naphthobenzothiophene, etc.

Wherein when $R^{11}$, $R^{12}$, $R^{13}$, $R^{14}$ and $R^{15}$ are a fused ring group, preferably a fused ring group of a $C_3$-$C_{30}$ aliphatic ring and a $C_6$-$C_{30}$ aromatic ring, and more preferably a fused ring group of a $C_3$-$C_{25}$ aliphatic ring and a $C_6$-$C_{25}$ aromatic ring.

Wherein when $R^{11}$, $R^{12}$, $R^{13}$, $R^{14}$ and $R^{15}$ are a alkyl group, preferably a $C_1$-$C_{30}$ alkyl group, more preferably a $C_1$-$C_{25}$ alkyl group, a $C_1$-$C_{18}$ alkyl group or a $C_1$-$C_{12}$ alkyl group, such as a methyl group, ethyl group, propyl group, isopropyl group, butyl group, t-butyl group, pentyl group, etc.

Wherein when $R^{11}$, $R^{12}$, $R^{13}$, $R^{14}$ and $R^{15}$ are a alkoxyl group, preferably a $C_1$-$C_{25}$ alkoxyl group, more preferably a $C_1$-$C_{18}$ alkoxyl group, a $C_1$-$C_{12}$ alkoxyl group.

Wherein when $R^{11}$, $R^{12}$, $R^{13}$, $R^{14}$ and $R^{15}$ are a aryloxy group, preferably a $C_6$-$C_{25}$ aryloxy group, more preferably a $C_6$-$C_{18}$ aryloxy group, a $C_6$-$C_{12}$ aryloxy group.

$L^1$, $L^2$ and $L^3$ are independently selected from the group consisting of single bond; a $C_6$-$C_{60}$ arylene group; a fluorenylene group; a fused ring group of a $C_3$-$C_{60}$ aliphatic ring and a $C_6$-$C_{60}$ aromatic ring; and a $C_2$-$C_{60}$ heterocyclic group including at least one heteroatom of O, N, S, Si and P;

Wherein when $L^1$, $L^2$ and $L^3$ are a arylene group, preferably an $C_6$-$C_{30}$ arylene group, more preferably an $C_6$-$C_{25}$ arylene group, an $C_6$-$C_{18}$ arylene group or an $C_6$-$C_{12}$ arylene group, such as phenylene, biphenylene, naphthylene, terphenylene, anthracenylene, phenanthrenylene etc.

Wherein when $L^1$, $L^2$ and $L^3$ are a heterocyclic group, preferably a $C_2$-$C_{30}$ heterocyclic group, more preferably a $C_2$-$C_{25}$ heterocyclic group, a $C_2$-$C_{18}$ heterocyclic group, or a $C_2$-$C_{12}$ heterocyclic group, such as pyrazine, thiophene, pyridine, pyrimidine, quinoline, pyrimidoindole, 5-phenyl-5H-pyrimido[5,4-b]indole, quinazoline, quinoxaline, benzoquinazoline, carbazole, dibenzoquinazoline, benzofuran, benzothiophene, dibenzofuran, dibenzothiophene, benzothienopyrimidine, benzofuropyrimidine, phenothiazine, phenylphenothiazine, benzocarbazole, naphthobenzofuran, naphthobenzothiophene, etc.

Wherein when $L^1$, $L^2$ and $L^3$ are a fused ring group, preferably a fused ring group of a $C_3$-$C_{30}$ aliphatic ring and a $C_6$-$C_{30}$ aromatic ring, and more preferably a fused ring group of a $C_3$-$C_{25}$ aliphatic ring and a $C_6$-$C_{25}$ aromatic ring.

$Ar^1$ and $Ar^2$ are independently selected from the group consisting of a $C_6$-$C_{60}$ aryl group; a $C_2$-$C_{60}$ heterocyclic group including at least one heteroatom of O, N, S, Si and P; a fluorenyl group; a fused ring group of a $C_3$-$C_{60}$ aliphatic ring and a $C_6$-$C_{60}$ aromatic ring; a $C_1$-$C_{50}$ alkyl group; a $C_2$-$C_{20}$ alkenyl group; a $C_2$-$C_{20}$ alkynyl group; a $C_3$-$C_{60}$ cycloalkyl group; a $C_1$-$C_{30}$ alkoxyl group; and

a $C_6$-$C_{30}$ aryloxy group;

Wherein when $Ar^1$ and $Ar^2$ are an aryl group, preferably an $C_6$-$C_{30}$ aryl group, more preferably an $C_6$-$C_{25}$ aryl group, an $C_6$-$C_{18}$ aryl group or an $C_6$-$C_{12}$ aryl group, such as phenyl, biphenyl, terphenyl, naphthalene, phenanthrene, chrysene, etc.

wherein when $Ar^1$ and $Ar^2$ are a heterocyclic group, preferably a $C_2$-$C_{30}$ heterocyclic group, more preferably a $C_2$-$C_{25}$ heterocyclic group, a $C_2$-$C_{18}$ heterocyclic group, or a $C_2$-$C_{12}$ heterocyclic group, such as pyrazine, thiophene, pyridine, pyrimidine, quinoline, pyrimidoindole, 5-phenyl-5H-pyrimido[5,4-b]indole, quinazoline, quinoxaline, benzoquinazoline, carbazole, dibenzoquinazoline, benzofuran, benzothiophene, dibenzofuran, dibenzothiophene, benzothienopyrimidine, benzofuropyrimidine, phenothiazine, phenylphenothiazine, benzocarbazole, naphthobenzofuran, naphthobenzothiophene, etc.

Wherein when $Ar^1$ and $Ar^2$ are a fused ring group, preferably a fused ring group of a $C_3$-$C_{30}$ aliphatic ring and a $C_6$-$C_{30}$ aromatic ring, and more preferably a fused ring group of a $C_3$-$C_{25}$ aliphatic ring and a $C_6$-$C_{25}$ aromatic ring.

wherein when $Ar^1$ and $Ar^2$ are a cycloalkyl group; preferably an $C_3$-$C_{30}$ cycloalkyl group, more preferably an $C_3$-$C_{25}$ cycloalkyl group, an $C_3$-$C_{18}$ cycloalkyl group or an $C_3$-$C_{12}$ cycloalkyl group, specifically, cyclobutane, cyclopentane, cyclohexane, bicycloheptane, adamantyl.

Wherein when $Ar^1$ and $Ar^2$ are an alkyl group, preferably a $C_1$-$C_{30}$ alkyl group, more preferably a $C_1$-$C_{25}$ alkyl group, a $C_1$-$C_{18}$ alkyl group or a $C_1$-$C_{12}$ alkyl group, such as a methyl group, ethyl group, propyl group, isopropyl group, butyl group, t-butyl group, pentyl group, etc.

wherein when $Ar^1$ and $Ar^2$ are a alkoxyl group, preferably a $C_1$-$C_{25}$ alkoxyl group, more preferably a $C_1$-$C_{18}$ alkoxyl group, a $C_1$-$C_{12}$ alkoxyl group.

wherein when $Ar^1$ and $Ar^2$ are a aryloxy group, preferably a $C_6$-$C_{25}$ aryloxy group, more preferably a $C_6$-$C_{18}$ aryloxy group, a $C_6$-$C_{12}$ aryloxy group.

$R^1$ and $R^2$ are independently the same or different from each other and are independently selected from the group consisting of hydrogen; deuterium; halogen; cyano group; nitro group; a $C_6$-$C_{60}$ aryl group; a fluorenyl group; a $C_2$-$C_{60}$ heterocyclic group including at least one heteroatom of O, N, S, Si and P; a fused ring group of a $C_3$-$C_{60}$ aliphatic ring and a $C_6$-$C_{60}$ aromatic ring; and a $C_1$-$C_{50}$ alkyl group; a $C_2$-$C_{20}$ alkenyl group; a $C_2$-$C_{20}$ alkynyl group; a $C_1$-$C_{30}$ alkoxyl group; and a $C_6$-$C_{30}$ aryloxy group; or a plurality of adjacent groups thereof may be bonded to each other to form a ring,

Wherein when $R^1$ and $R^2$ are an aryl group, preferably an $C_6$-$C_{30}$ aryl group, more preferably an $C_6$-$C_{25}$ aryl group, an $C_6$-$C_{18}$ aryl group or an $C_6$-$C_{12}$ aryl group, such as phenyl, biphenyl, terphenyl, naphthalene, phenanthrene,

chrysene, etc.

Wherein when $R^1$ and $R^2$ are a heterocyclic group, preferably a $C_2$-$C_{30}$ heterocyclic group, more preferably a $C_2$-$C_{25}$ heterocyclic group, a $C_2$-$C_{18}$ heterocyclic group, or a $C_2$-$C_{12}$ heterocyclic group, such as pyrazine, thiophene, pyridine, pyrimidine, quinoline, pyrimidoindole, 5-phenyl-5H-pyrimido[5,4-b]indole, quinazoline, quinoxaline, benzoquinazoline, carbazole, dibenzoquinazoline, benzofuran, benzothiophene, dibenzofuran, dibenzothiophene, benzothienopyrimidine, benzofuropyrimidine, phenothiazine, phenylphenothiazine, benzocarbazole, naphthobenzofuran, naphthobenzothiophene, etc.

Wherein when $R^1$ and $R^2$ are a fused ring group, preferably a fused ring group of a $C_3$-$C_{30}$ aliphatic ring and a $C_6$-$C_{30}$ aromatic ring, and more preferably a fused ring group of a $C_3$-$C_{25}$ aliphatic ring and a $C_6$-$C_{25}$ aromatic ring.

Wherein when $R^1$ and $R^2$ are an alkyl group, preferably a $C_1$-$C_{30}$ alkyl group, more preferably a $C_1$-$C_{25}$ alkyl group, a $C_1$-$C_{18}$ alkyl group or a $C_1$-$C_{12}$ alkyl group, such as a methyl group, ethyl group, propyl group, isopropyl group, butyl group, t-butyl group, pentyl group, etc.

Wherein when $R^1$ and $R^2$ are a alkoxyl group, preferably a $C_1$-$C_{25}$ alkoxyl group, more preferably a $C_1$-$C_{18}$ alkoxyl group, a $C_1$-$C_{12}$ alkoxyl group.

Wherein when $R^1$ and $R^2$ are a aryloxy group, preferably a $C_6$-$C_{25}$ aryloxy group, more preferably a $C_6$-$C_{18}$ aryloxy group, a $C_6$-$C_{12}$ aryloxy group.

a is an integer of 0 to 4, b is an integer of 0 to 3,

wherein the aryl group, arylene group, heterocyclic group, fluorenyl group, fluorenylene group, fused ring group, alkyl group, alkenyl group, alkynyl group, cycloalkyl group, alkoxy group and aryloxy group may be substituted with one or more substituents selected from the group consisting of deuterium; halogen; silane group; siloxane group; boron group; germanium group; a cyano group; a nitro group; a $C_1$-$C_{20}$ alkylthio group; a $C_1$-$C_{20}$ alkoxyl group; a $C_6$-$C_{20}$ aryloxy group; a $C_1$-$C_{20}$ alkyl group; a $C_2$-$C_{20}$ alkenyl group; a $C_2$-$C_{20}$ alkynyl group; a $C_6$-$C_{20}$ aryl group; a $C_6$-$C_{20}$ aryl group substituted with deuterium; a fluorenyl group; a $C_2$-$C_{20}$ heterocyclic group; a $C_3$-$C_{20}$ aliphatic ring; a $C_7$-$C_{20}$ arylalkyl group; a $C_8$-$C_{20}$ arylalkenyl group; and a $C_7$-$C_{20}$ alkylaryl group, and the hydrogen of these substituents may be further substituted with one or more deuterium, and the substituents may be bonded to each other to form a saturated or unsaturated ring, wherein the term 'ring' means a $C_3$-$C_{60}$ aliphatic ring or a $C_6$-$C_{60}$ aromat ic ring or a $C_2$-$C_{60}$ heterocyclic group or a fused ring formed by the combination thereof.

Also, Formula 1 is represented by the following Formula 1-1 or Formula 1-2.

<Formula 1-1>

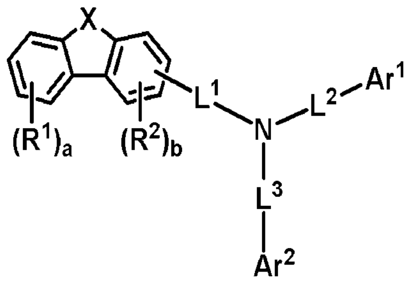

<Formula 1-2>

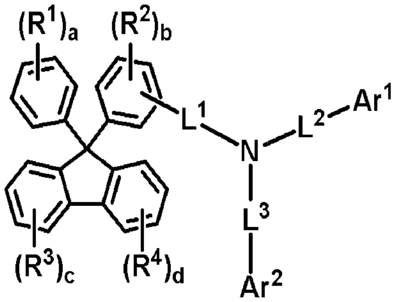

wherein:

$R^1$, $R^2$, a, b, X, $L^1$, $L^2$, $L^3$, $Ar^1$ and $Ar^2$ are the same as defined in Formula 1,

$R^3$ and $R^4$ are independently the same or different from each other and are independently selected from the group consisting of hydrogen; deuterium; halogen; cyano group; nitro group; a $C_6$-$C_{20}$ aryl group; a fluorenyl group; a $C_2$-$C_{20}$ heterocyclic group including at least one heteroatom of O, N, S, Si and P; a fused ring group of a $C_3$-$C_{20}$ aliphatic ring and a $C_6$-$C_{20}$ aromatic ring; and a $C_1$-$C_{20}$ alkyl group; a $C_2$-$C_{20}$ alkenyl group; a $C_2$-$C_{20}$ alkynyl group; a $C_1$-$C_{20}$ alkoxyl group; and a $C_6$-$C_{20}$ aryloxy group; or a plurality of adjacent groups thereof may be bonded to each other to form a ring,

c and de are independently an integer of 0 to 4.

Also, Formula 1 is represented by the following Formula 2-1 or Formula 2-2.

<Formula 2-1>

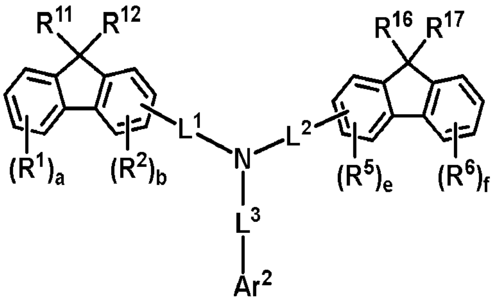

<Formula 2-2>

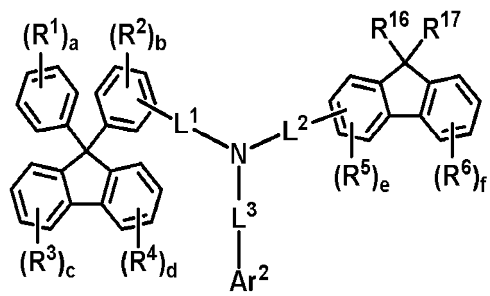

wherein,

$R^1$, $R^2$, a, b, $R^{11}$, $R^{12}$, $L^1$, $L^2$, $L^3$, $Ar^1$ and $Ar^2$ are the same as defined in Formula 1,

$R^3$, $R^4$, $R^5$, $R^6$, $R^{16}$ and $R^{17}$ are the same as the definition of $R^3$, or adjacent groups thereof may be bonded to each other to form a ring,

e is an integer of 0 to 3, c, d, and f are independently an integer of 0 to 4.

Specifically, the compound represented by Formula 1 may be any one of the following compounds, but is not limited thereto.

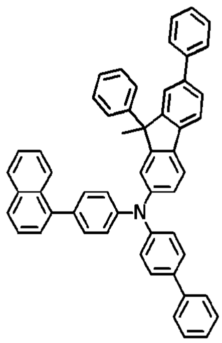

1-1

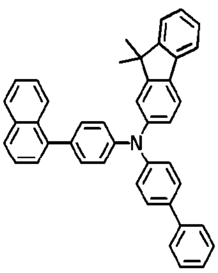

1-2

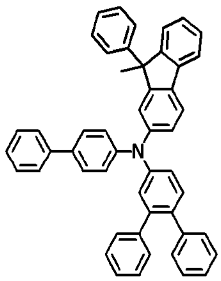

1-3

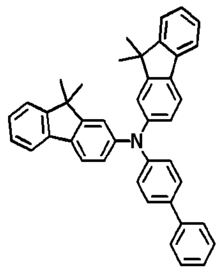

1-4

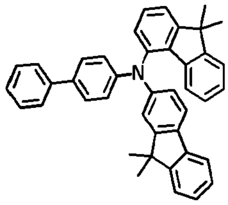

1-5

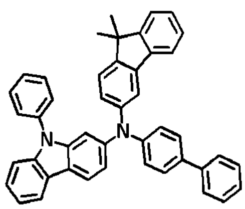

1-6

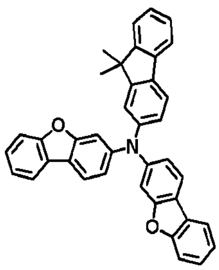

1-7

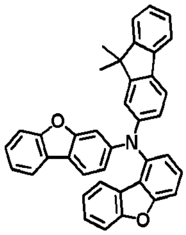

1-8

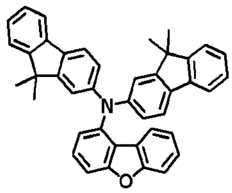

1-9

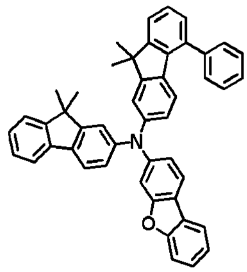

1-10

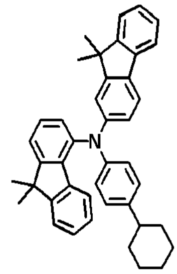
1-11

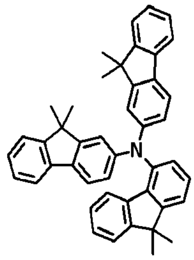
1-12

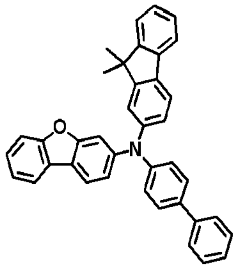
1-13

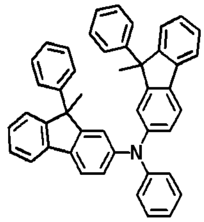
1-14

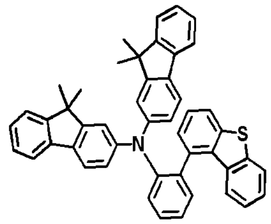
1-15

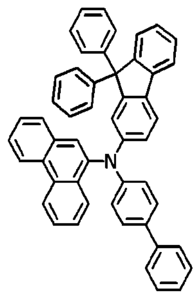
1-16

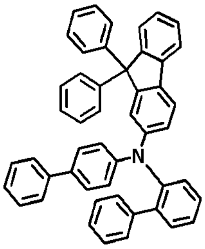
1-17

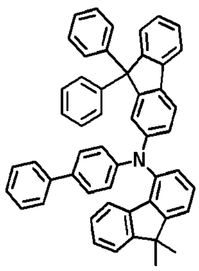
1-18

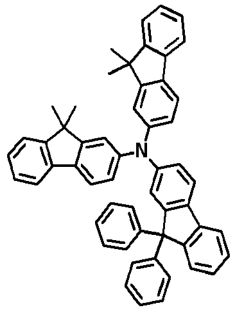
1-19

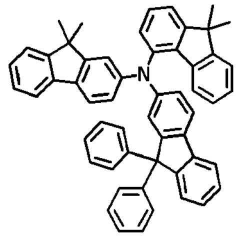
1-20

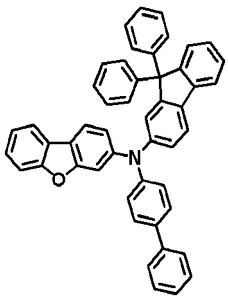
1-21

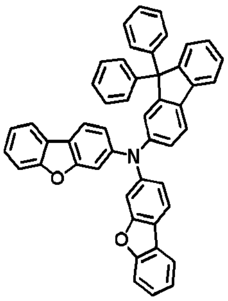
1-22

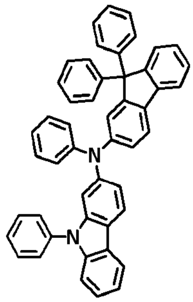
1-23

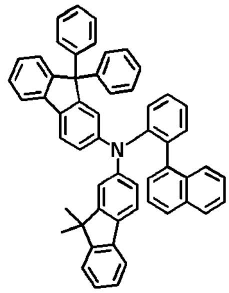
1-24

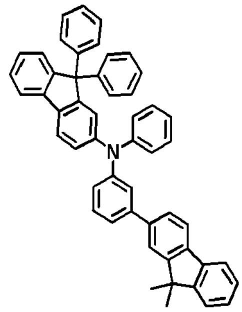
1-25

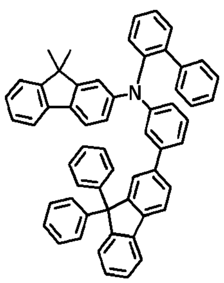
1-26

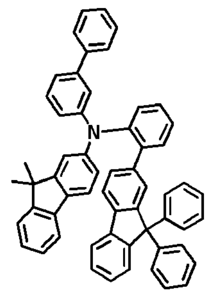
1-27

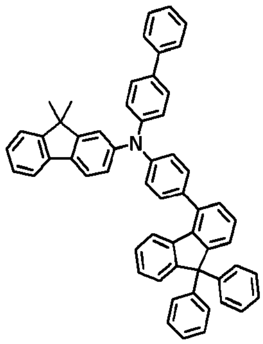
1-28

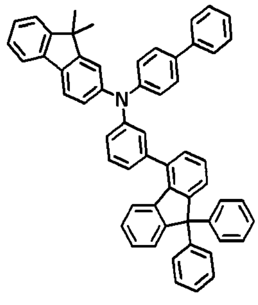
1-29

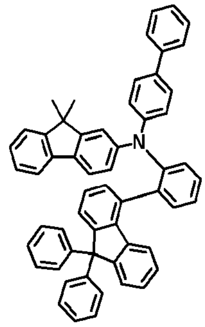
1-30

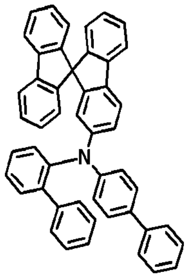
1-31

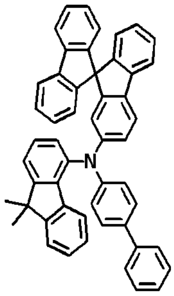
1-32

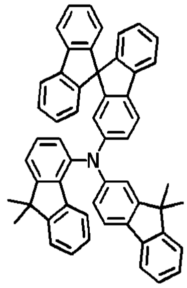
1-33

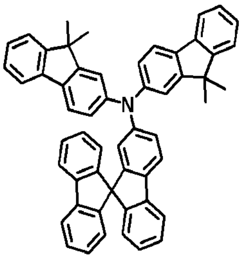
1-34

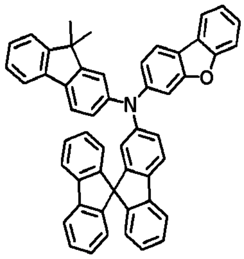
1-35

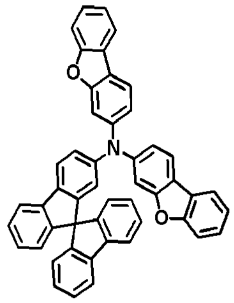
1-36

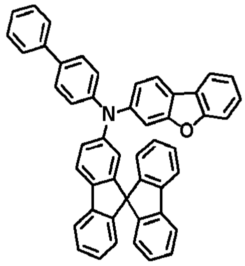
1-37

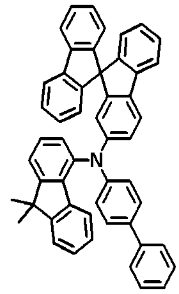
1-38

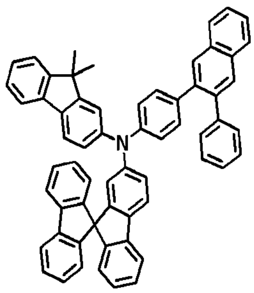
1-39

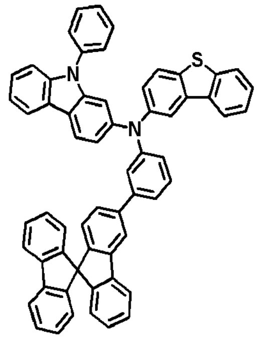
1-40

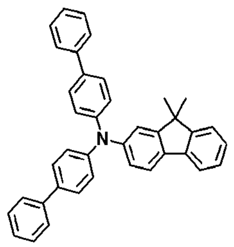
1-41

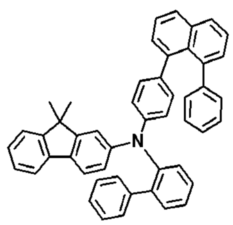
1-42

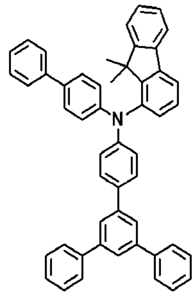
1-43

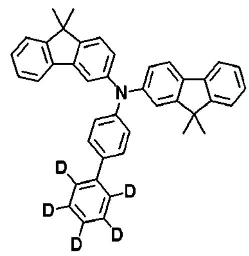
1-44

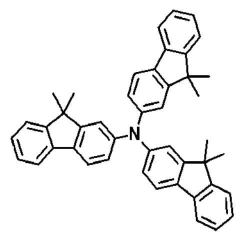
1-45

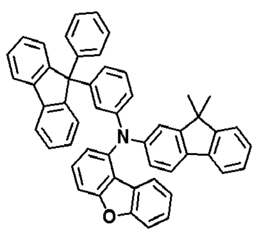
2-1

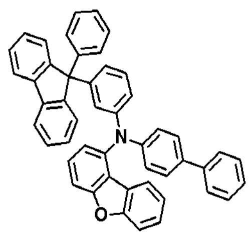
2-2

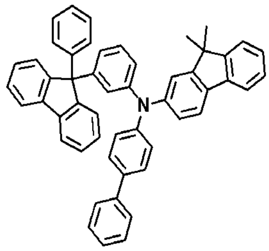
2-3

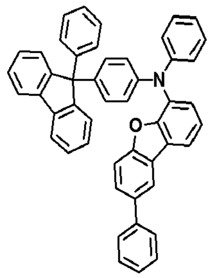
2-4

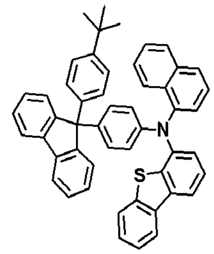
2-5

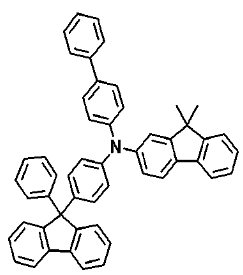
2-6

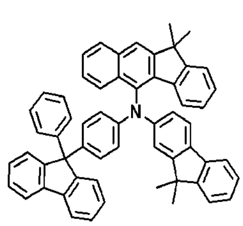
2-7

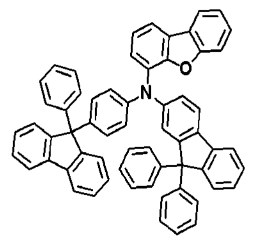
2-8

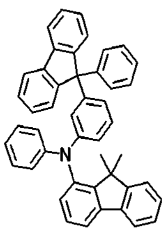
2-9

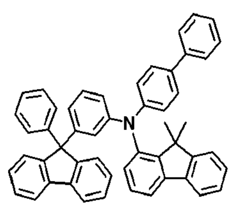
2-10

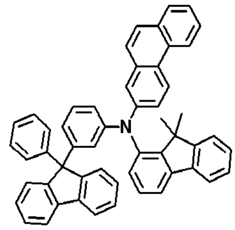
2-11

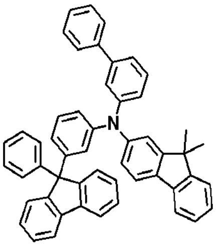
2-12

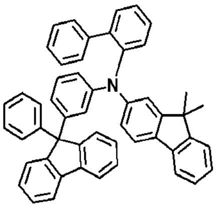
2-13

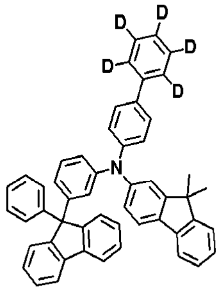
2-14

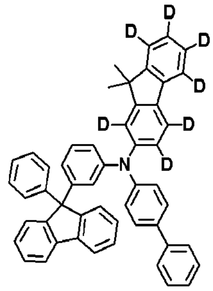
2-15

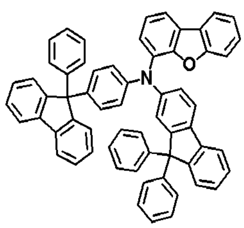
2-16

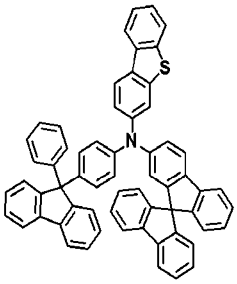
2-17

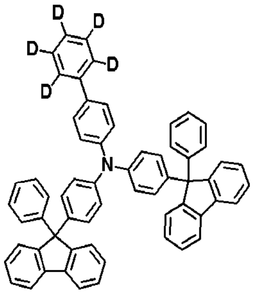
2-18

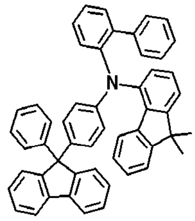
2-19

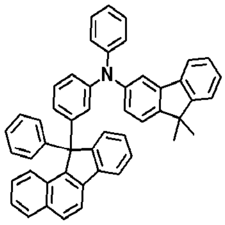
2-20

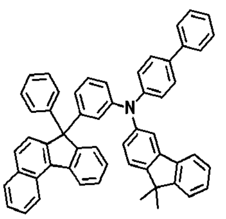
2-21

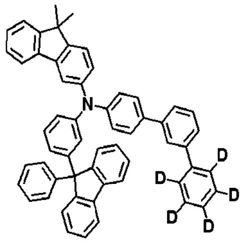
2-22

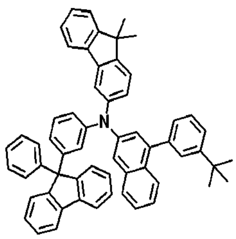
2-23

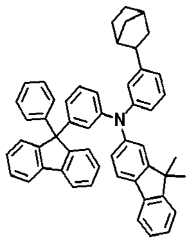
2-24

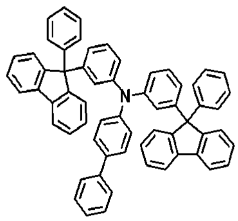
2-25

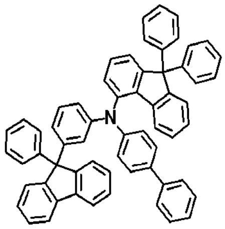
2-26

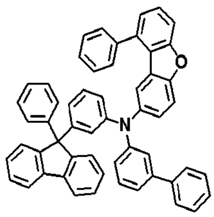
2-27

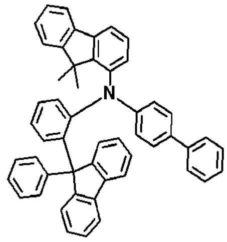
2-28

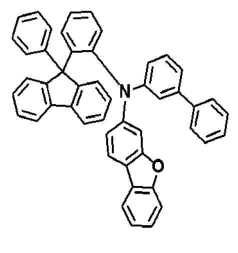
2-29

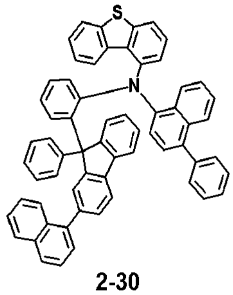
2-30

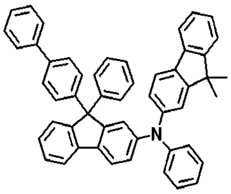
3-1

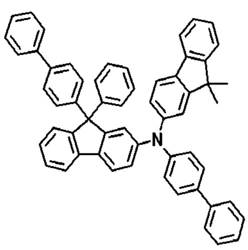
3-2

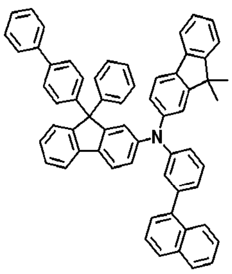
3-3

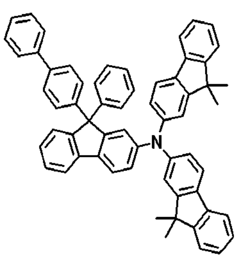
3-4

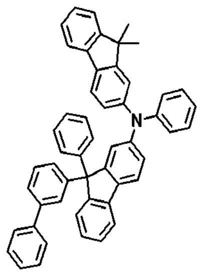
3-5

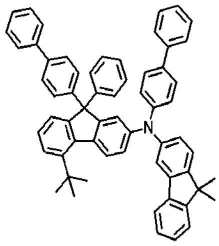
3-6

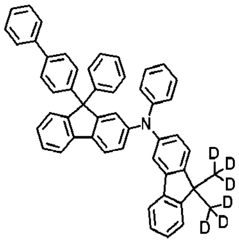
3-7

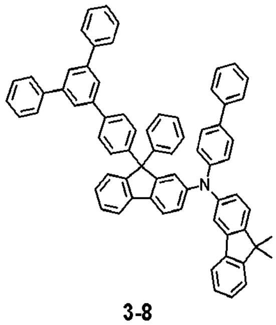
3-8

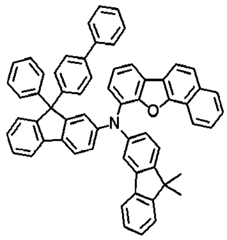
3-9

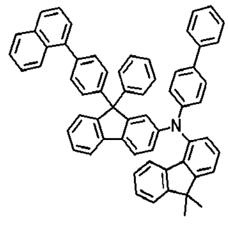
3-10

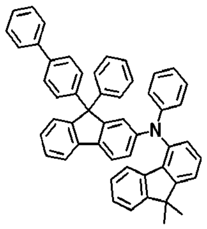
3-11

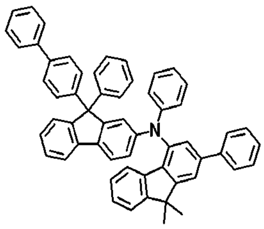
3-12

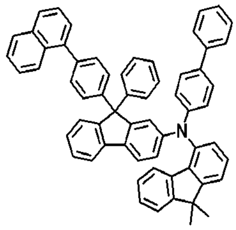
3-13

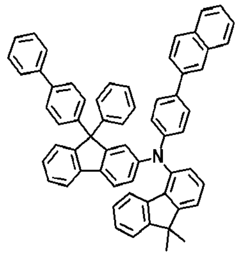
3-14

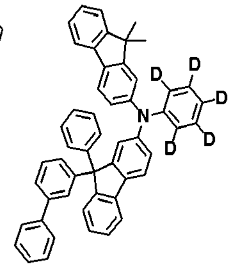
3-15

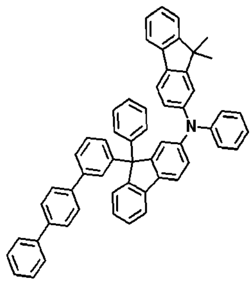
3-16

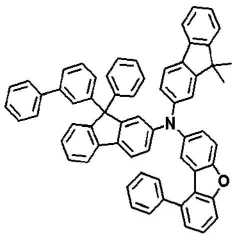
3-17

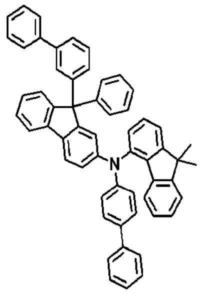
3-18

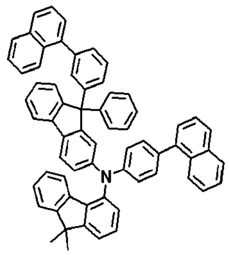
3-19

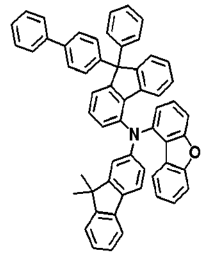
3-20

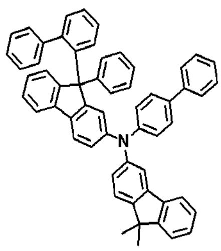
3-21

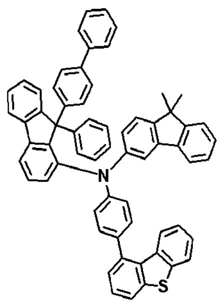
3-22

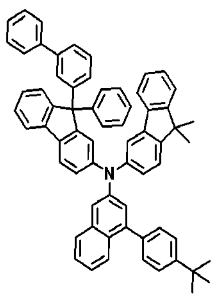
3-23

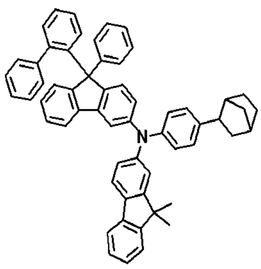
3-24

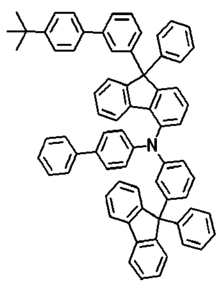
3-25

The present invention may further comprise a light efficiency enhancing layer formed on at least one surface of the first electrode and the second electrode, the surface opposite to the organic material layer.

Additionally, the organic material layer may comprise 2 or more stacks comprising a hole transport layer, an emitting layer and an electron transport layer sequentially formed on the anode, and may further comprise a charge generation layer formed between the 2 or more stacks According to another aspect, the present invention also provides an electronic device comprising a display device comprising the organic electronic element; and a control unit for driving the display device. Wherein the organic electronic element is at least one of an OLED, an organic solar cell, an organic photo conductor, an organic transistor and an element for monochromic or white illumination.

Hereinafter, Synthesis examples of the compound represented by Formula 1 of the present invention, and preparation examples of the organic electronic element will be described in detail by way of example, but are not limited to the following examples.

**[Synthesis Example]**

The compound (final products) represented by Formula 1 according to the present invention can be synthesized by a reaction as in Reaction Scheme 1, but is not limited thereto. ($Hal^1$= Br, I or Cl)

< Reaction Scheme 1>

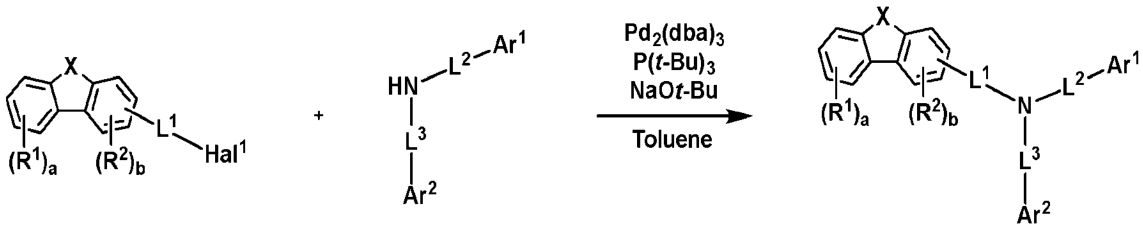


**Sub 1** **Sub 2** **Final product**

I. Synthesis of Final Product

1. Synthesis of 1-2

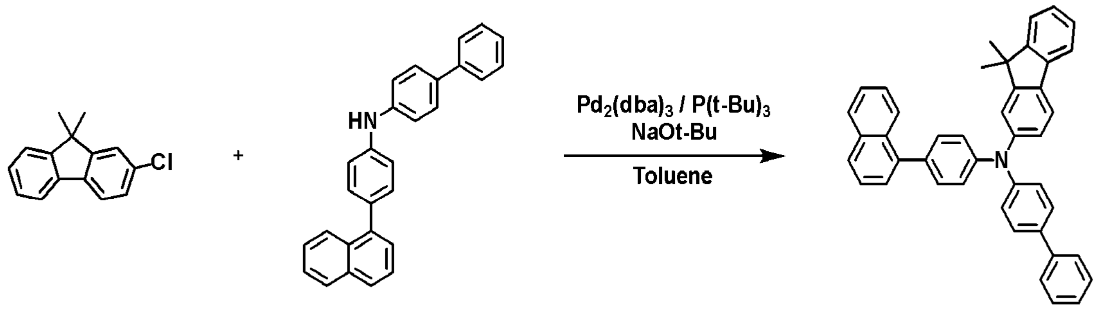


**Sub 1-1** **Sub 2-1** **1-2**

Sub 1-1 (15.0 g, 61.3 mmol) was dissolved in Toluene (300 mL) in a roundbottom flask, Sub 2-1 (22.8 g, 61.3 mmol), $Pd_2(dba)_3$ (1.7 g, 1.8 mmol), $P(t\text{-}Bu)_3$ (0.7 g, 3.7 mmol), NaO*t*-Bu (11.8 g, 122.6 mmol) were added, and stirred at 80° C. After the reaction was completed, the mixture was extracted with $CH_2Cl_2$ and water, the organic layer was dried over $MgSO_4$ and concentrated, and the resulting compound was purified by silica gel column and sublimation to obtain 27.3 g of the product (yield: 79%).

2. Synthesis of 1-15

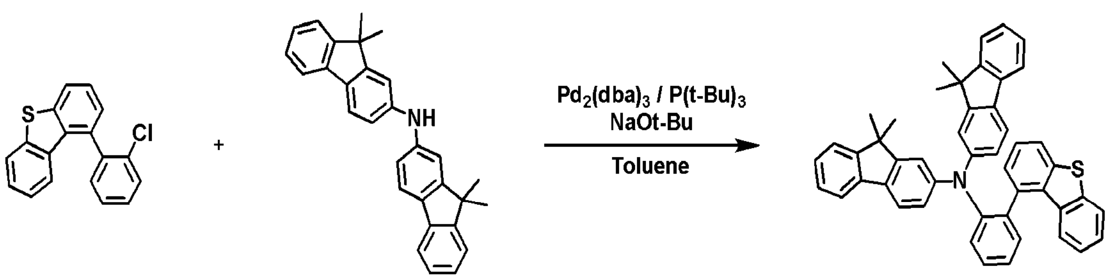


**Sub 1-2** **Sub 2-2** **1-15**

Sub 1-2 (10.0 g, 33.9 mmol) was dissolved in Toluene (250 mL) in a roundbottom flask, Sub 2-2 (13.6 g, 33.9 mmol), $Pd_2(dba)_3$ (0.9 g, 1.0 mmol), *P*(*t*-Bu)$_3$ (0.4 g, 2.0 mmol), NaOt-Bu (6.5 g, 67.8 mmol) were added, and 16.8 g of the product (yield: 75%) was obtained using the synthetic method of 1-2.

3. Synthesis of 2-1

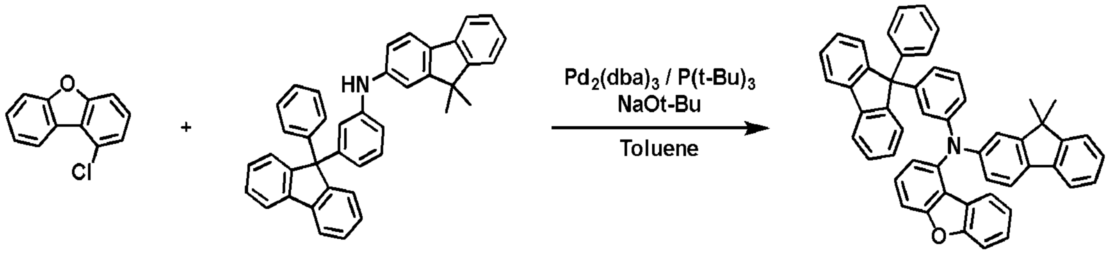


**Sub 1-3** **Sub 2-3** **2-1**

Sub 1-3 (20.0 g, 98.7 mmol) was dissolved in Toluene (400 mL) in a roundbottom flask, Sub 2-3 (51.9 g, 98.7 mmol), $Pd_2(dba)_3$ (2.7 g, 3.0 mmol), P(t-Bu)$_3$ (1.2 g, 5.9 mmol), NaOt-Bu (19.0 g, 197.4 mmol) were added, and 54.6 g of the product (yield: 80%) was obtained using the synthetic method of 1-2.

4. Synthesis of 3-5

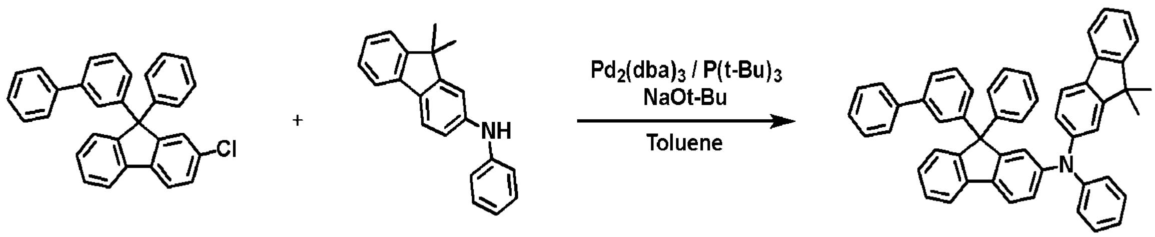


**Sub 1-4** **Sub 2-4** **3-5**

Sub 1-4 (20.0 g, 46.6 mmol) was dissolved in Toluene (400 mL) in a roundbottom flask, Sub 2-4 (13.3 g, 46.6 mmol), $Pd_2(dba)_3$ (1.3 g, 1.4 mmol), *P*(*t*-Bu)$_3$ (0.6 g, 2.8 mmol), NaO*t*-Bu (9.0 g, 93.3 mmol) were added, and 24.3 g of the product (yield: 77%) was obtained using the synthetic method of 1-2.

Meanwhile, exemplary synthesis examples of the present invention represented by Formula 1 have been described, but these are all based on the Buchwald-Hartwig cross coupling reaction, Miyaura boration reaction, Suzuki cross-coupling reaction, Intramolecular acid-induced cyclization reaction (J. mater. Chem.1999, 9, 2095.), Pd(II)-catalyzed oxidative cyclization reaction (Org. Lett.2011, 13, 5504), and $PPh_3$-mediated reductive cyclization reaction (J. Org. Chem. 2005, 70, 5014.), and it will be easily understood by those skilled in the art that the reaction proceeds even when other substituents defined in Formula 1 are bonded in addition to the substituents specified in the specific synthesis examples.

Capacitance measurement experiment example

An impedance meter was used to measure capacitance (nF), which represents the ratio of the amount of charge accumulated according to charge mobility. Impedance measurement can evaluate charge transfer characteristics in bulk or interfacial regions of ions, semiconductors, and insulators, and is also an effective method for analyzing the electrical properties of materials and their interfaces with electrodes in OLEDs.

In particular, the hole accumulation phenomenon can be confirmed by checking whether there is a change in capacitance according to the mobility of holes from the anode to the hole transport layer. If the capacitance increases from the beginning, it can be seen that the hole accumulation phenomenon occurs because the holes cannot move smoothly at

the hole transport layer interface and accumulate.

In the present invention, an ALPHA-AN Analyzer was used as an impedance meter, and a jig having a BNC (input)/RF (output) terminal was used. The measurement conditions were based on a frequency of 120 Hz, similar to the frequency of a gaming monitor, the DC voltage was swept from 0 V to 4 V in 0.01-inch increments, and the AC voltage was set to ±0.1 V.

A TEG device substrate with an anode formed as ITO/Ag/ITO(100Å/1000Å/100 Å) on a glass substrate (35 mm×35 mm×0.7 mm thickness) used as a device fabrication substrate and a light-emitting area of 2 mm×2 mm was used.

The substrate was cleaned by sonication at an ultrasonic frequency of 40 kHz with IPA for 10 minutes and DI water for 10 minutes, and then stored in an oven at 90° C for 20 hours to remove moisture before use.

In order to process reproducible devices, the substrate plasma conditions, device thickness, HIL and HTL deposition rates, crucible size, and distance between the crucible and the substrate were standardized, and the conditions are as follows.

The Plasma PT (Pre-Treatment) process conditions were Pressure: 15(mTorr) / MFC:$N_2$:$O_2$ =40:0.2(sccm) / RF Power : 200(W) / Time : 90(s). The total thickness of the device excluding the substrate is 2665Å, and the HIL was manufactured with a thickness of 50Å and the HTL with a thickness of 1400Å. The deposition rate of the HIL was 1Å/s, and the deposition rate of the HTL was 2Å/s. The 20cc crucible was used, and the distance between the crucible and the substrate was 600 mm.

The compounds listed in Table 1 were used as hole transport layer materials, and the other devices were manufactured under identical conditions. Figure 1 shows a graph of capacitance-voltage data measured for the hole transport layer materials, based on a 120Hz and ±0.1V measurement standard.

[Table 1]

| | hole transport layer materials |
|---|---|
| comparative example 1 | comparative compound 1 |
| comparative example 2 | comparative compound 2 |
| comparative example 3 | comparative compound 3 |
| example | 3-5 |

[comparative compound 1] [comparative compound 2] [comparative compound 3]

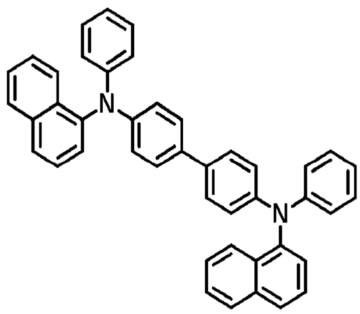
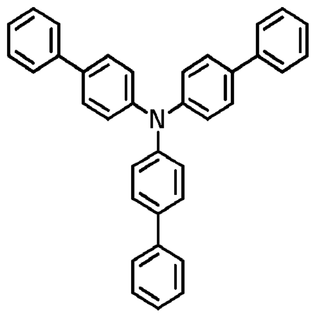
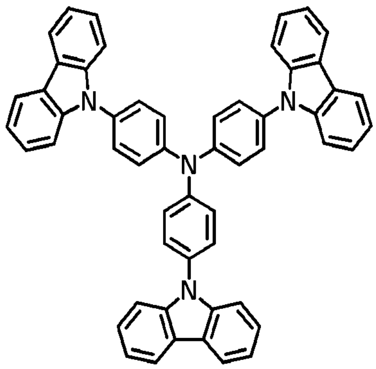

To explain Fig. 1 in detail, in the -2 V region, since not enough voltage is applied for holes to move, all devices have capacitance (nF) values that do not increase from the baseline, and it can be seen that hole injection begins from the hole injection layer to the hole transport layer from the -0.5 V region.

In the case of Comparative Compound 1, the capacitance begins to increase significantly at -0.5 V, and continues to increase between 0 V and 1 V, and the capacitance at 1 V was measured to be more than 1 nF. In the case of Comparative Compounds 2 and 3, the capacitance does not increase significantly at -0.5 V, but it can be confirmed that the capacitance increases to more than 1 nF between 0 V and 1 V. These results indicate that when Comparative Compounds 1 to 3 are used as hole transport layer materials, holes continue to accumulate inside or at the interface of the hole transport layer, preventing the holes from moving smoothly and causing the holes to stagnate, resulting in an increase in capacitance due to the residual holes.

In contrast, in the case of compounds 3-5 according to the present invention, unlike the devices using comparative compounds 1 to 3 as hole transport layer materials, the change in capacitance from -0.5 V to 1 V was

not large, and the capacitance at 1 V was measured to be less than 1 nF. This means that the time for charges to accumulate inside or at the interface of the hole transport layer is shortened, so that charges are smoothly supplied to the emitting layer, and as a result, the charge balance of holes and electrons in the emitting layer increases, which can solve the low-gray phenomenon and enhance the stability of the OLED device.

Table 2 shows the results of measuring the capacitance values in the low voltage region (-0.5 V, 0 V, 1 V) according to the hole transport layer material based on the measurement standard of 120 Hz and ±0.1 V.

[Table 2]

| | Hole transport layer material | Capacitance (nF) at -0.5V | Capacitance (nF) at OV | Capacitance (nF) at \1V |
|---|---|---|---|---|
| comparative example 1 | comparative compound 1 | 0.82 | 1.10 | 1.50 |
| comparative example 2 | comparative compound 2 | 0.61 | 0.86 | 1.33 |
| comparative example 3 | comparative compound 3 | 0.60 | 0.82 | 1.27 |
| example 1 | 3-5 | 0.60 | 0.63 | 0.64 |
| example 2 | 3-11 | 0.59 | 0.61 | 0.66 |
| example 3 | 3-24 | 0.60 | 0.64 | 0.67 |
| example 4 | 2-2 | 0.61 | 0.63 | 0.66 |
| example 5 | 2-14 | 0.60 | 0.65 | 0.70 |
| example 6 | 2-25 | 0.59 | 0.62 | 0.68 |
| example 7 | 1-9 | 0.61 | 0.65 | 0.71 |
| example 8 | 1-11 | 0.60 | 0.62 | 0.66 |
| example 9 | 1-31 | 0.60 | 0.63 | 0.68 |
| example 10 | 1-42 | 0.60 | 0.62 | 0.65 |

The elements using Comparative Compounds 1 to 3 as hole transport layer materials showed a significant increase in capacitance between 0 V and 1 V, as described in Fig. 1, and the capacitance at 1 V was measured to be 1 nF or more.

In contrast, it was confirmed that in Examples 1 to 10, the difference between the capacitance at 0 V and the capacitance at 1 V was maintained without significant change at 0.1 nF or less, and through this, it was confirmed that the holes that moved from the hole injection layer to the hole transport layer did not accumulate and moved smoothly to the emitting layer.

**Experimental example of progressive driving voltage measurement**

The progressive driving voltages of Comparative Examples 4 to 6 and Example 11 were measured, and the results are shown in Fig. 5. The progressive driving voltage refers to the increase in voltage due to deterioration of the element when the element is placed in the life equipment. The lifespan measurement equipment used was the Maxscience M6000 PLUS OLED Lifetime Tester, and the progressive driving voltage of the element was calculated by applying a specific current density to the element to generate light and calculating the difference in voltage over time between the initial voltage value and the voltage over time.

Referring to FIG. 5 in detail, as a result of measuring the progressive driving voltage of the devices manufactured by Comparative Examples 4 to 6 and Example 11 at 85° C, it can be seen that the elements manufactured with Comparative Compounds 1 to 3 having a capacitance of 1 nF or more in the low-voltage region, the progressive driving voltage of Comparative Examples 4 to 6 increases significantly, and the elements manufactured with compound 3-5 of the present invention having a capacitance of less than 1 nF in a low voltage region, the progressive driving voltage increase change of Example 11 is not significant. A significant increase in the progressive driving voltage can degrade the stability of the element, resulting in increased power consumption and reduced lifespan. Consequently, using a compound with a capacitance of less than 1 nF as the hole transport layer material in the low-voltage region can improve the stability of the element, as the progressive driving voltage change is minimal.

**Manufacturing Evaluation of Organic light-emitting devices**

**[Example 11] Green Organic light-emitting Device (hole transport layer)**

A hole injection layer was formed by vacuum-depositing 4,4',4"-Tris[2-naphthyl(phenyl)amino]triphenylamine (hereinafter abbreviated as 2-TNATA) to a thickness of 60 nm on an ITO layer (anode) formed on a glass substrate, and then a hole transport layer was formed by vacuum-depositing compound 3-5 of the present invention to a thickness of 60 nm on the hole injection layer. Next, an emitting layer was formed by vacuum-depositing 4,4'-N,N'-dicarbazole-biphenyl (hereinafter abbreviated as CBP) as a host material and tris(2-phenylpyridine)-iridium (hereinafter, (Ir(ppy)$_3$) as a dopant material on the hole transport layer at a weight ratio of 90:10 to a thickness of 30 nm. Next, (1,1'-biphenyl-4-olato)bis(2-methyl-8-quinolinolato)aluminum (hereinafter, BAlq) was vacuum-deposited to a thickness of 10 nm on the emitting layer to form a hole-blocking layer, and tris-(8-hydroxyquinoline)aluminum (hereinafter, Alq$_3$) was vacuum-deposited to a thickness of 40 nm on the hole-blocking layer to form an electron transport layer. Afterwards, LiF, a halogenated alkali metal, was deposited to a thickness of 0.2 nm to form an electron injection layer, and then Al was deposited to a thickness of 150 nm to form a cathode, thereby manufacturing an organic light-emitting device.

**[Example 12] and [Example 13]**

An organic light-emitting device was manufactured in the same manner as Example 11, except that the compound of the present invention described in Table 4 below was used instead of the compound 3-5 of the present invention as the hole transport layer material.

**[Comparative Example 4] to [Comparative Example 6]**

An organic light-emitting device was manufactured in the same manner as Example 11, except that Comparative Compounds 1 to 3 were used instead of Compound 3-5 of the present invention as the hole transport layer material.

The electroluminescence (EL) characteristics were measured using PR-650 from Photoresearch by applying a forward bias DC voltage to the organic light-emitting devices manufactured by Comparative Examples 4 to 6 and Examples 11 to 13. As a result of the measurement, the T95 lifespan was measured using a lifespan measuring device manufactured by Max Science at a standard brightness of 5,000 cd/m$^2$. Table 3 shows the results.

The measuring apparatus can evaluate the performance of new materials compared to comparative compounds under identical conditions, without being affected by possible daily fluctuations in deposition rate, vacuum quality or other parameters. During the evaluation, one batch contains 4 identically prepared OLEDs including a comparative compound, and the performance of a total of 12 OLEDs is evaluated in 3 batches, so the value of the experimental results obtained in this way indicates statistical significance.

[Table 3]

| | Hole transport layer | Driving Voltage (V) | Current Density (mA/cm$^2$) | Brightness (cd/m$^2$) | Efficiency (cd/A) | T(95) |
|---|---|---|---|---|---|---|
| comparative example 4 | comparative compound 1 | 5.8 | 23.3 | 5000.0 | 21.5 | 81.4 |
| comparative example 5 | comparative compound 2 | 5.7 | 21.1 | 5000.0 | 23.7 | 86.5 |
| comparative example 6 | comparative compound 3 | 5.6 | 19.1 | 5000.0 | 26.2 | 92.1 |
| example 11 | 3-5 | 5.4 | 13.8 | 5000.0 | 36.3 | 110.9 |
| example 12 | 2-2 | 5.4 | 13.5 | 5000.0 | 37.0 | 111.4 |
| example 13 | 1-42 | 5.3 | 13.7 | 5000.0 | 36.4 | 111.7 |

As can be seen from Table 3, in the case of element performance using Comparative Compounds 1 to 3 as hole transport layer materials, which showed a capacitance increase of 1 nF or more between 0 V and 1 V based on 120 Hz and ±0.1 V measurements, holes continue to accumulate inside or at the interface of the hole transport layer, preventing the holes from moving smoothly and causing them to stagnate, which relatively slows down charge injection into the emitting layer, leading to an imbalance in the charge balance in the emitting layer, which reduces not only the driving voltage but also the efficiency and lifespan. In contrast, in the case of the elements of Examples 11 to 13 using the compound of the present invention, in which the capacitance was measured to be less than 1 nF between 0 V and 1 V based on 120 Hz and ±0.1 V measurements, as a hole transport layer material, charge supply to the emitting layer was smoothly achieved, and the stability of the OLED device increased due to excellent charge mobility, thereby improving the overall driving voltage,

efficiency, and lifespan of the element.

Although exemplary embodiments of the present invention have been described for illustrative purposes, those skilled in the art will appreciate that various modifications, additions and substitutions are possible, without departing from the scope and spirit of the invention as disclosed in the accompanying claims. Therefore, the embodiment disclosed in the present invention is intended to illustrate the scope of the technical idea of the present invention, and the scope of the present invention is not limited by the embodiment. The scope of the present invention shall be construed on the basis of the accompanying claims, and it shall be construed that all of the technical ideas included within the scope equivalent to the claims belong to the present invention.

**[Industrial Applicability]**

According to the present invention, organic elements with excellent element characteristics such as high brightness, high luminescence, and long lifespan can be manufactured, thus demonstrating industrial applicability.

## Claims

1. An organic electronic element comprising: a first electrode; a second electrode; and at least one organic material layer between the first electrode and the second electrode; wherein the organic material layer comprises a hole transport region, an emitting layer, and an electron transport region,
   wherein the hole transport region has a capacitance of less than 1 nF within a range of 0 V to 1 V when measuring capacitance-voltage under conditions of 120 Hz and ±0.1 V.

2. The organic electronic element according to claim 1, wherein the hole transport region has a difference between the capacitance at 0 V and the capacitance at 1 V of 0.01 nF to 0.3 nF when measuring capacitance-voltage under the conditions of 120 Hz and ± 0.1 V.

3. The organic electronic element according to claim 1, wherein the hole transport region has a difference between the capacitance at 0 V and the capacitance at 1 V of less than 0.1 nF when measuring capacitance-voltage under the conditions of 120 Hz and ± 0.1 V.

4. The organic electronic element according to claim 1, wherein the hole transport region comprises at least one hole injection layer and at least one hole transport layer.

5. The organic electronic element according to claim 1, wherein the organic electronic element comprises at least one emitting auxiliary layer between the hole transport region and the emitting layer.

6. The organic electronic element according to claim 1, wherein the hole transport region with a capacitance of less than 1 nF within the range of 0 V to 1 V is the hole transport layer, when measuring capacitance-voltage under conditions of 120 Hz and ± 0.1 V.

7. The organic electronic element according to claim 6, wherein the hole transport layer comprises a compound represented by Formula 1:

<Formula 1>

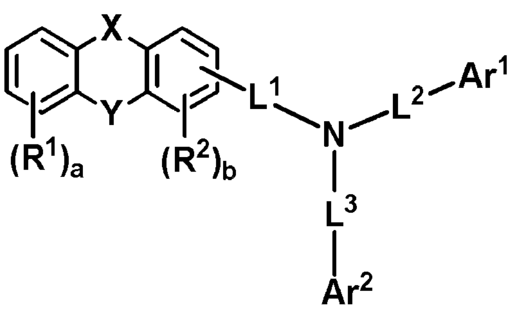

wherein:

X is O, S, $CR^{11}R^{12}$ or $NR^{13}$,
Y is single bond; or $CR^{14}R^{15}$; or non-existent,
$R^{11}$, $R^{12}$, $R^{13}$, $R^{14}$ and $R^{15}$ are independently selected from the group consisting of a $C_6$-$C_{60}$ aryl group; a $C_2$-$C_{60}$ heterocyclic group including at least one heteroatom of O, N, S, Si and P; a fluorenyl group; a fused ring group of a $C_3$-$C_{60}$ aliphatic ring and a $C_6$-$C_{60}$ aromatic ring; a $C_1$-$C_{50}$ alkyl group; a $C_2$-$C_{20}$ alkenyl group; a $C_2$-$C_{20}$ alkynyl group; a $C_1$-$C_{30}$ alkoxy group; and a $C_6$-$C_{30}$ a aryloxy group; and $R^{11}$ and $R^{12}$ or $R^{14}$ and $R^{15}$ may be bonded to each other to form a ring,
$L^1$, $L^2$ and $L^3$ are independently selected from the group consisting of single bond; a $C_6$-$C_{60}$ arylene group; a fluorenylene group; a fused ring group of a $C_3$-$C_{60}$ aliphatic ring and a $C_6$-$C_{60}$ aromatic ring; and a $C_2$-$C_{60}$ heterocyclic group including at least one heteroatom of O, N, S, Si and P;
$Ar^1$ and $Ar^2$ are independently selected from the group consisting of a $C_6$-$C_{60}$ aryl group; a $C_2$-$C_{60}$ heterocyclic group including at least one heteroatom of O, N, S, Si and P; a fluorenyl group; a fused ring group of a $C_3$-$C_{60}$ aliphatic ring and a $C_6$-$C_{60}$ aromatic ring; a $C_1$-$C_{50}$ alkyl group; a $C_2$-$C_{20}$ alkenyl group; a $C_2$-$C_{20}$ alkynyl group; a $C_3$-$C_{60}$ cycloalkyl group; a $C_1$-$C_{30}$ alkoxyl group; and
a $C_6$-$C_{30}$ aryloxy group;
$R^1$ and $R^2$ are independently the same or different from each other and are independently selected from the group consisting of hydrogen; deuterium; halogen; cyano group; nitro group; a $C_6$-$C_{60}$ aryl group; a fluorenyl group; a $C_2$-$C_{60}$ heterocyclic group including at least one heteroatom of O, N, S, Si and P; a fused ring group of a $C_3$-$C_{60}$ aliphatic ring and a $C_6$-$C_{60}$ aromatic ring; and a $C_1$-$C_{50}$ alkyl group; a $C_2$-$C_{20}$ alkenyl group; a $C_2$-$C_{20}$ alkynyl group; a $C_1$-$C_{30}$ alkoxyl group; and a $C_6$-$C_{30}$ aryloxy group; or a plurality of adjacent groups thereof may be bonded to each other to form a ring,
a is an integer of 0 to 4, b is an integer of 0 to 3,
wherein the aryl group, arylene group, heterocyclic group, fluorenyl group, fluorenylene group, fused ring group, alkyl group, alkenyl group, alkynyl group, cycloalkyl group, alkoxy group and aryloxy group may be substituted with one or more substituents selected from the group consisting of deuterium; halogen; silane group; siloxane group; boron group; germanium group; a cyano group; a nitro group; a $C_1$-$C_{20}$ alkylthio group; a $C_1$-$C_{20}$ alkoxyl group; a $C_6$-$C_{20}$ aryloxy group; a $C_1$-$C_{20}$ alkyl group; a $C_2$-$C_{20}$ alkenyl group; a $C_2$-$C_{20}$ alkynyl group; a $C_6$-$C_{20}$ aryl group; a $C_6$-$C_{20}$ aryl group substituted with deuterium; a fluorenyl group; a $C_2$-$C_{20}$ heterocyclic group; a $C_3$-$C_{20}$ aliphatic ring; a $C_7$-$C_{20}$ arylalkyl group; a $C_8$-$C_{20}$ arylalkenyl group; and a $C_7$-$C_{20}$ alkylaryl group, and the hydrogen of these substituents may be further substituted with one or more deuterium, and the substituents may be bonded to each other to form a saturated or unsaturated ring, wherein the term 'ring' means a $C_3$-$C_{60}$ aliphatic ring or a $C_6$-$C_{60}$ aromatic ring or a $C_2$-$C_{60}$ heterocyclic group or a fused ring formed by the combination thereof.

**8.** The organic electronic element according to claim 7, wherein Formula 1 is represented by the following Formula 1-1 or Formula 1-2:

<Formula 1-1>

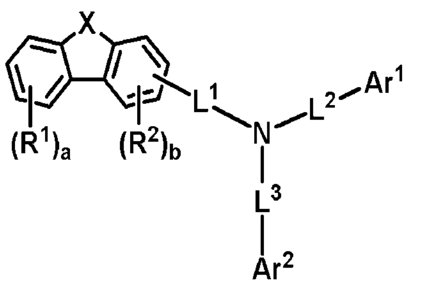

<Formula 1-2>

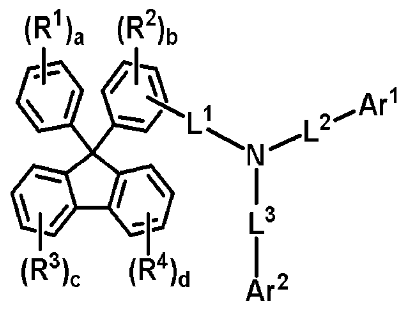

wherein:

$R^1$, $R^2$, a, b, X, $L^1$, $L^2$, $L^3$, $Ar^1$ and $Ar^2$ are the same as defined in claim 7,
$R^3$ and $R^4$ are independently the same or different from each other and are independently selected from the group consisting of hydrogen; deuterium; halogen; cyano group; nitro group; a $C_6$-$C_{20}$ aryl group; a fluorenyl group; a $C_2$-$C_{20}$ heterocyclic group including at least one heteroatom of O, N, S, Si and P; a fused ring group of a $C_3$-$C_{20}$ aliphatic ring and a $C_6$-$C_{20}$ aromatic ring; and a $C_1$-$C_{20}$ alkyl group; a $C_2$-$C_{20}$ alkenyl group; a $C_2$-$C_{20}$ alkynyl group; a $C_1$-$C_{30}$ alkoxyl group; and a $C_6$-$C_{20}$ aryloxy group; or a plurality of adjacent groups thereof may be bonded to each other to form a ring,

c and de are independently an integer of 0 to 4.

**9.** The organic electronic element according to claim 7, wherein Formula 1 is represented by the following Formula 2-1 or Formula 2-2:

<Formula 2-1>

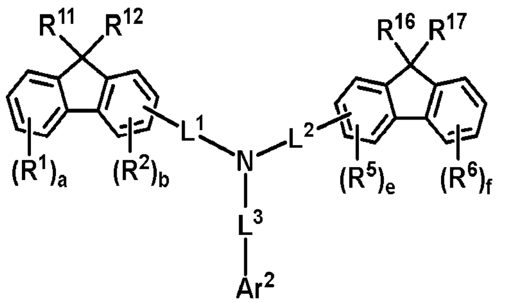

<Formula 2-2>

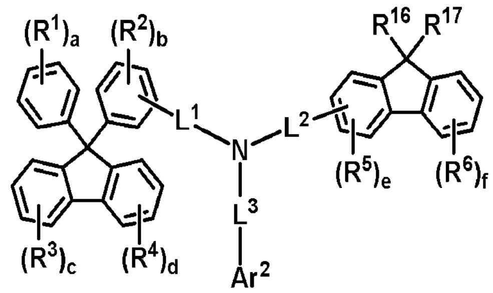

wherein,

$R^1$, $R^2$, a, b, $R^{11}$, $R^{12}$, $L^1$, $L^2$, $L^3$, $Ar^1$ and $Ar^2$ are the same as defined in claim 7,
$R^3$, $R^4$, $R^5$, $R^6$, $R^{16}$ and $R^{17}$ are the same as the definition of $R^3$ in claim 8, or adjacent groups thereof may be bonded to each other to form a ring,
e is an integer of 0 to 3, c, d, and f are independently an integer of 0 to 4.

**10.** The organic electronic element according to claim 1, further comprising a light efficiency enhancing layer formed on at least one surface of the first electrode and the second electrode, the surface being opposite to the organic material layer.

**11.** The organic electronic element according to claim 1, wherein the organic material layer comprises 2 or more stacks including a hole transport layer, an emitting layer, and an electron transport layer sequentially formed on a first electrode.

**12.** The organic electronic element according to claim 11, wherein the organic material layer further comprises a charge generation layer formed between the 2 or more stacks.

**13.** An electronic device comprising a display device comprising the organic electronic element of claim 1; and a control unit for driving the display device.

**14.** The electronic device according to claim 13, wherein the organic electronic element is at least one of an OLED, an organic solar cell, an organic photo conductor(OPC), organic transistor (organic TFT) and an element for monochromic or white illumination.

FIG. 1

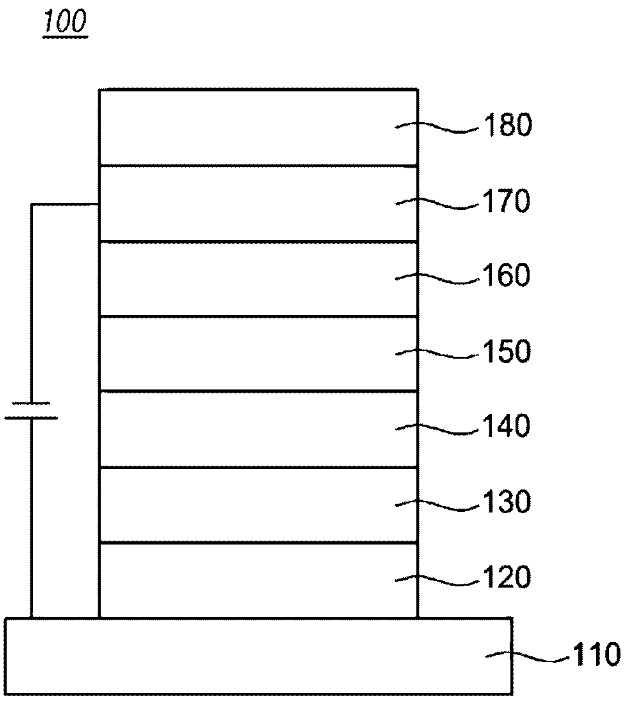

FIG. 2

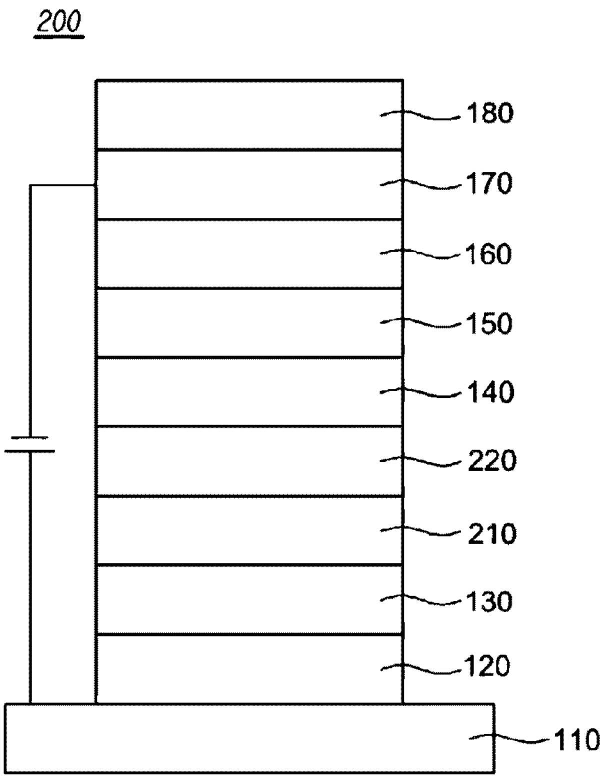

FIG. 3

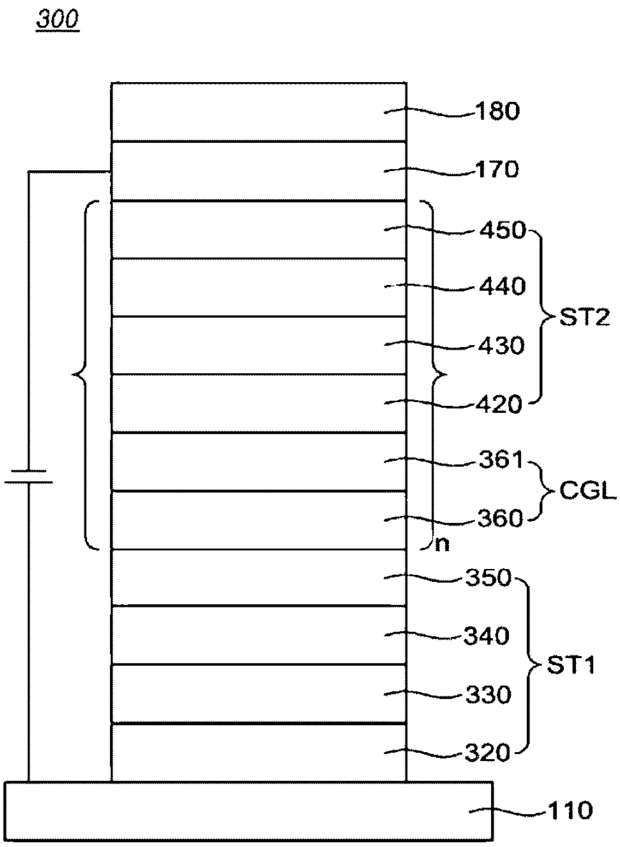
300
180
170
450
440
430
420
ST2
361
360
CGL
n
350
340
330
320
ST1
110

FIG. 4

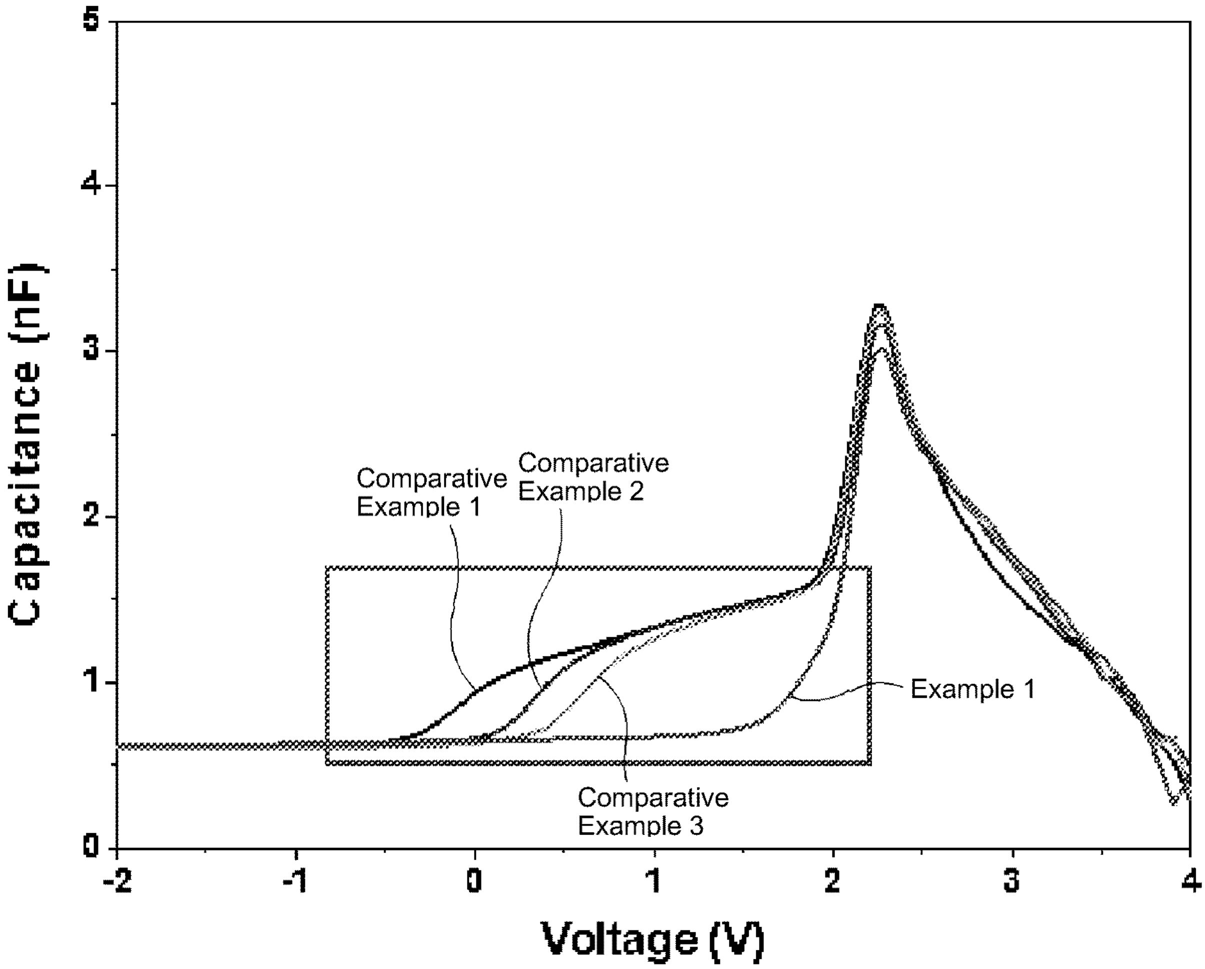
Capacitance (nF)
Voltage (V)
0
1
2
3
4
5
-2
-1
0
1
2
3
4
Comparative Example 1
Comparative Example 2
Comparative Example 3
Example 1

FIG. 5

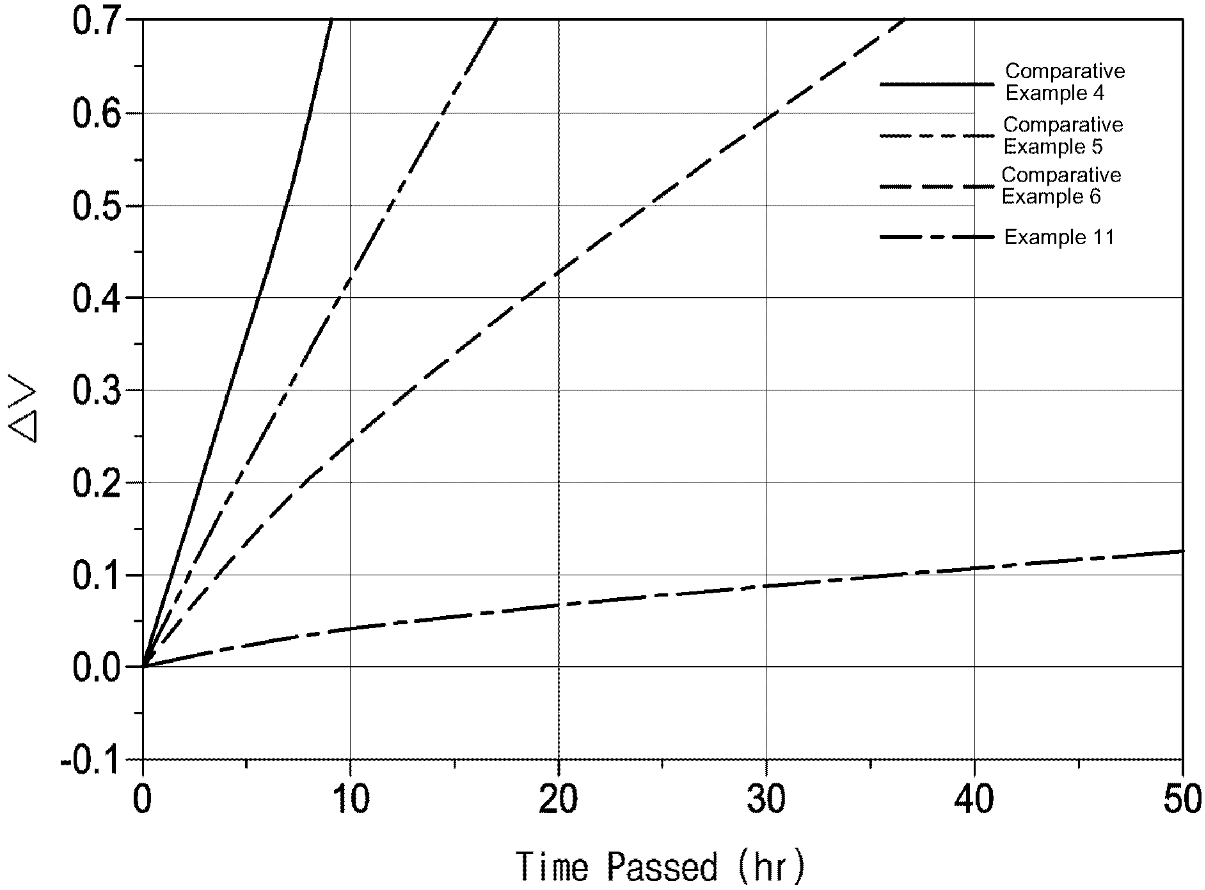
0.7
0.6
0.5
0.4
0.3
0.2
0.1
0.0
-0.1
ΔV
0
10
20
30
40
50
Time Passed (hr)
Comparative Example 4
Comparative Example 5
Comparative Example 6
Example 11

**INTERNATIONAL SEARCH REPORT**

International application No. **PCT/KR2024/009135**

**A. CLASSIFICATION OF SUBJECT MATTER**

**H10K 50/15**(2023.01)i; **H10K 50/11**(2023.01)i; **H10K 50/16**(2023.01)i; **H10K 50/81**(2023.01)i; **H10K 50/82**(2023.01)i; **H10K 50/17**(2023.01)i; **H10K 50/19**(2023.01)i; **H10K 50/85**(2023.01)i; **H10K 59/10**(2023.01)i; **H10K 30/50**(2023.01)i

According to International Patent Classification (IPC) or to both national classification and IPC

**B. FIELDS SEARCHED**

Minimum documentation searched (classification system followed by classification symbols)

H10K 50/15(2023.01); C07C 209/10(2006.01); C07C 211/54(2006.01); C07C 211/61(2006.01); C07D 209/82(2006.01); C07D 413/14(2006.01); H01L 51/00(2006.01); H01L 51/50(2006.01); H10K 50/00(2023.01); H10K 99/00(2023.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal), STN (Registry, Caplus), PubChem & keywords: 유기물층 (organic material layer), 정공수송영역 (hole transport region), 커패시턴스-전압 (capacitance-voltage)

**C. DOCUMENTS CONSIDERED TO BE RELEVANT**

| Category* | Citation of document, with indication, where appropriate, of the relevant passages | Relevant to claim No. |
|---|---|---|
| | KR 10-2018-0041581 A (ROHM AND HAAS ELECTRONIC MATERIALS KOREA LTD.) 24 April 2018 (2018-04-24) | |
| X | See claims 1, 2, 4 and 7; and paragraphs [0056], [0074], [0075] and [0185]-[0187]. | 1-9 |
| Y | | 10,13,14 |
| A | | 11,12 |
| | KR 10-2020-0082020 A (LG DISPLAY CO., LTD. et al.) 08 July 2020 (2020-07-08) | |
| X | See claims 1, 7 and 8; paragraphs [0061]-[0063], [0067], [0173], [0191], [0192] and [0230]; and figure 4. | 1-4,6-8,11,12 |
| Y | | 10,13,14 |
| | KR 10-2020-0113087 A (DUK SAN NEOLUX CO., LTD.) 06 October 2020 (2020-10-06) | |
| Y | See claims 5-7, 11 and 12. | 10,13,14 |

☑ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **17 October 2024** | **17 October 2024** |
| Name and mailing address of the ISA/KR<br>**Korean Intellectual Property Office**<br>**Government Complex-Daejeon Building 4, 189 Cheongsa-ro, Seo-gu, Daejeon 35208**<br>Facsimile No. **+82-42-481-8578** | Authorized officer<br><br>Telephone No. |

Form PCT/ISA/210 (second sheet) (July 2022)

INTERNATIONAL SEARCH REPORT

International application No. **PCT/KR2024/009135**

**C. DOCUMENTS CONSIDERED TO BE RELEVANT**

| Category* | Citation of document, with indication, where appropriate, of the relevant passages | Relevant to claim No. |
|---|---|---|
| X<br>Y | US 2022-0173333 A1 (CHANGCHUN HYPERIONS TECHNOLOGY CO., LTD.) 02 June 2022 (2022-06-02)<br>See claims 6, 7 and 10 (pages 175 and 177); and paragraphs [0059]-[0060]. | 1-4,6-9<br>10,13,14 |
| X<br>Y | KR 10-2017-0134163 A (LG CHEM, LTD.) 06 December 2017 (2017-12-06)<br>See claims 1, 5 and 10. | 1-4,6-8<br>10,13,14 |
| X<br>Y | KR 10-2013-0099098 A (MERCK PATENT GMBH) 05 September 2013 (2013-09-05)<br>See claims 1, 3, 4, 13 and 14; and paragraphs [0116] and [0117]. | 1-4,6-9<br>10,13,14 |

Form PCT/ISA/210 (second sheet) (July 2022)

**INTERNATIONAL SEARCH REPORT**
**Information on patent family members**

International application No.
**PCT/KR2024/009135**

| Patent document cited in search report | Publication date (day/month/year) | Patent family member(s) | Publication date (day/month/year) |
|---|---|---|---|
| KR 10-2018-0041581 A | 24 April 2018 | CN 109804045 A | 24 May 2019 |
| | | KR 10-2520279 B1 | 12 April 2023 |
| | | US 2020-0028082 A1 | 23 January 2020 |
| | | WO 2018-070821 A1 | 19 April 2018 |
| KR 10-2020-0082020 A | 08 July 2020 | CN 111509132 A | 07 August 2020 |
| | | CN 111509132 B | 14 July 2023 |
| | | EP 3675193 A1 | 01 July 2020 |
| | | EP 3675193 B1 | 20 July 2022 |
| | | KR 10-2702683 B1 | 03 September 2024 |
| | | US 11380853 B2 | 05 July 2022 |
| | | US 2020-0212312 A1 | 02 July 2020 |
| KR 10-2020-0113087 A | 06 October 2020 | KR 10-2638040 B1 | 20 February 2024 |
| US 2022-0173333 A1 | 02 June 2022 | CN 112442023 A | 05 March 2021 |
| | | CN 112442023 B | 24 August 2021 |
| | | EP 4006025 A1 | 01 June 2022 |
| | | JP 2022-087059 A | 09 June 2022 |
| | | JP 7262138 B2 | 21 April 2023 |
| | | KR 10-2022-0077093 A | 08 June 2022 |
| KR 10-2017-0134163 A | 06 December 2017 | KR 10-1961346 B1 | 25 March 2019 |
| KR 10-2013-0099098 A | 05 September 2013 | CN 103108859 A | 15 May 2013 |
| | | CN 103108859 B | 22 June 2016 |
| | | DE 102010045405 A1 | 15 March 2012 |
| | | EP 2616428 A1 | 24 July 2013 |
| | | EP 2616428 B1 | 24 December 2014 |
| | | JP 2013-544757 A | 19 December 2013 |
| | | JP 5917521 B2 | 18 May 2016 |
| | | KR 10-1663355 B1 | 06 October 2016 |
| | | KR 10-2016-0114729 A | 05 October 2016 |
| | | KR 10-2019-0004368 A | 11 January 2019 |
| | | KR 10-2107365 B1 | 07 May 2020 |
| | | TW 201229007 A | 16 July 2012 |
| | | TW I503300 B | 11 October 2015 |
| | | US 2013-0207046 A1 | 15 August 2013 |
| | | US 2016-0190447 A1 | 30 June 2016 |
| | | US 9312495 B2 | 12 April 2016 |
| | | US 9947874 B2 | 17 April 2018 |
| | | WO 2012-034627 A1 | 22 March 2012 |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description

- *J. mater. Chem.*, 1999, vol. 9, 2095
- *Org. Lett.*, 2011, vol. 13, 5504
- *J. Org. Chem.*, 2005, vol. 70, 5014